# EUROPÄISCHE PATENTSCHRIFT

(11) **EP 0 938 783 B1**
(45) Veröffentlichungstag und Bekanntmachung des Hinweises auf die Patenterteilung: **05.09.2001**
(21) Anmeldenummer: 97949886.2
(22) Anmeldetag: 03.11.1997
(51) Int. Cl.: H04B 1/69

(54) **VERFAHREN ZUR DRAHTLOSEN ÜBERTRAGUNG EINER NACHRICHT**
METHOD FOR WIRELESS INFORMATION TRANSFER
PROCEDE DE TRANSMISSION SANS FIL D'UNE INFORMATION

(30) Priorität: 01.11.1996 DE 19646747
(43) Veröffentlichungstag der Anmeldung: 01.09.1999
(60) Teilanmeldung: 01104837.8
(73) Patentinhaber: NANOTRON GESELLSCHAFT FÜR MIKROTECHNIK MBH, 10555 Berlin (DE)
(72) Erfinder: KOSLAR, Manfred, D-10629 Berlin (DE); IANELLI, Zbigniew, D-13355 Berlin (DE)
(74) Vertreter: Eisenführ, Speiser & Partner
(86) Internationale Anmeldenummer: DE9702606
(87) Internationale Veröffentlichungsnummer: WO9820625

(56) Entgegenhaltungen:
- WO-A-95/20277
- US-A- 4 255 791
- US-A- 5 070 500
- US-A- 5 105 294
- US-A- 5 113 278
- US-A- 5 325 394
- KOWATSCH ET AL.: "Spread-Spectrum-übertragung analoger Signale mit Chirp-Modulation" ARCHIV FÜR ELEKTRONIK UND ÜBERTRAGUNGSTECHNIK, Bd. 36, Juli 1982, Seiten 299-304, XP002061685
- MÄUSL: "Digitale Modulationsverfahren", 1995, HÜTHIG VERLAG, HEIDELBERG

## Beschreibung

Die Erfindung betrifft ein Verfahren gemäß dem Oberbegriff des Anspruchs 1 sowie eine Sender- und Empfänger-Anordnung zur Durchführung des Verfahrens gemäß dem Oberbegriff des Anspruchs 12, wie sie aus US-A 5 105 294 bzw. US 5 113 278 bekannt sind.

Bei bekannten, jedem Fachmann aus Standardwerken geläufigen drahtlosen Nachrichtenübertragungsverfahren wird das zu übertragende Nachrichtensignal im Sender durch einen Modulator einem hochfrequenten Trägersignal aufmoduliert und über eine Übertragungsstrecke dem Empfänger übermittelt, derzur Rückgewinnung des Nachrichtensignals einen entsprechenden Demodulator aufweist. Ein bekanntes Modulationsverfahren der Nachrichtentechnik ist die Winkelmodulation (als Oberbegriff für Frequenz- und Phasenmodulation).

Aus US-A 5 105 294 ist ein digitales Kommunikationsverfahren und eine entsprechende Vorrichtung bekannt, bei welcher Pulsgeneratoren vorgesehen sind, mittels derer Pulse mit einer einzigen Wellenlängenkomponente erzeugt werden.

Liegt das zu übertragende Nachrichtensignal in digitalisierter Form als Bitfolge vor, wie es vorzugsweise in modernen Mobilfunknetzen der Fall ist, so erfolgt die Modulation durch Änderung der Frequenz bzw. Phase oder der Amplitude des Trägersignals in Abhängigkeit von der zu übertragenden Bitfolge. Beispielsweise aus COUCH, L.W.: Digital and Analog Communication Systems, 4^{th} Edition, Macmillan Publishing Company (1993), sind verschiedene digitale Modulationsverfahren bekannt, darunter die Amplitudentastung (ASK: Amplitude Shift Keying), die Zweiphasenumtastung (2-PSK: Phase Shift Keying) oder die Zweifrequenzumtastung (2-FSK: Frequency Shift Keying). Auch hier erfolgt im Empfänger jeweils die Demodulation entsprechend dem senderseitig angewandten Modulationsverfahren und damit die Rückgewinnung des digitalen Nachrichtensignals als Bitfolge in Form von aufeinanderfolgenden Impulsen.

Dem Fachmann ist - etwa aus der analogen Fernsehtechnik, wo die Restseitenbandamplitudenmodulation für das Luminanzsignal, die Frequenzmodulation für das Audiosignal und die IQ-Modulation für das Chrominanzsignal genutzt werden - auch die Anwendung mehrerer verschiedener Modulationsverfahren für verschiedene Nachrichten bzw. Nachrichtenkomponenten im Rahmen eines zusammenhängenden Übertragungsvorganges geläufig. Auch hier dient die Variation der Trägerparameter einzig dem Aufprägen der Nachricht und hat keinen Einfluß auf Störungen der Übertragungsstrecke.

Aus der Radartechnik ist ein Verfahren zur senderseitigen Dehnung und empfängerseitigen Kompression der ausgesandten Ortungsimpulse ("Chirp"-Verfahren) bekannt; vgl. etwa E. Philippow (Hrsg.): Taschenbuch der Elektrotechnik, Band 4: Systeme der Informationstechnik, Berlin 1985, S. 340/341. Hierbei werden zur Kompression eine analoge Frequenzmodulation oder eine digitale Phasenmodulation angewandt, es erfolgt jedoch keine Aufprägung einer Nachricht. Dieses Verfahren dient der Herabsetzung der aufgewandten Sendeleistung und damit der Detektierbarkeit der Signale durch einen eventuellen Gegner bei gleichzeitiger Erhaltung der Erfassungsreichweite und -genauigkeit.

Bei allen Nachrichtenübertragungsverfahren besteht das grundsätzliche physikalische Problem, daß die Qualität des empfängerseitig zurückgewonnenen Nachrichtensignals mit (in der Praxis stets vorhandenen) Störungen auf der Übertragungsstrecke und infolgedessen mit der Entfernung zwischen Sender und Empfänger abnimmt. Um bei einer Nachrichtenübertragung auf einer störungsbehafteten Übertragungsstrecke eine gewünschte Feichweite mit einer vorgegebenen Störsicherheit zu erreichen, ist daher eine bestimmte Sendeleistung nötig, die beispielsweise bei der mobilen Kommunikation im Watt-Bereich liegt.

Der Erfindung liegt daher die Aufgabe zugrunde, ein Verfahren der eingangs genannten Art bzw. eine Anordnung zu dessen Durchführung zu schaffen, die bei mindestens gleichbleibender Übertragungsqualität eine Verringerung der Sendeleistung und/oder Erhöhung der Reichweite ermöglichen.

Diese Aufgabe wird mit einem Verfahren mit den Merkmalen nach Anspruch 1 bzw. durch eine Sender-Empfänger-Anordnung mit dem Merkmal nach Anspruch 12 gelöst. Vorteilhafte Weiterbildungen sind in den Unteransprüchen beschrieben.

Die Erfindung schließt den grundsätzlichen Gedanken ein, zwei voneinander unabhängige Modulationsverfahren dazu einzusetzen, zum einen die Nachricht einem Träger aufzuprägen (Informationssignalmodulation) und zum anderen eine weitgehende Unterdrückung von Störungen auf der Übertragungsstrecke, insbesondere des thermischen oder "weißen" Rauschens, zu erreichen (Trägersignalmodulation).

Die mittels eines an sich bekannten Verfahrens der Nachrichtentechnik mit der Nachricht modulierten bzw. zu modulierenden Impulse werden im Sender einer Winkelmodulation (was hier als Oberbegriff für Phasen- und Frequenzmodulation zu verstehen ist) mit einer speziellen Kennlinie unterzogen. Die winkelmodulierten, ein vorbestimmtes Frequenzspektrum aufweisenden Impulse werden im Empfänger durch Aufprägung einer frequenzabhängigen Verzögerung zeitlich komprimiert. Damit ergibt sich am Empfängerausgang - bezogen auf die Amplitude des Sendesignals und somit auch gegenüber dem Störpegel - eine Amplitudenüberhöhung. Diese Impulskompression/Amplitudenüberhöhung läßt sich insbesondere mittels eines dispersiven Filters durchführen. Aus dem so bearbeiteten Träger wird durch Demodulation das Informationssignal zurückgewonnen, wobei die InformationssignalDemodulation mit einem durch die Amplitudenüberhöhung verbesserten Signal-/Rauschverhältnis erfolgen kann.

Dessen Verbesserung ist abhängig vom Bandbreite-Zeit-Produkt aus der bei der Winkelmodulation eingesetzten Bandbreite und der Impulsdauer und bei schlechten Übertragungsbedingungen besonders markant.

Die eigentliche Nachricht kann dem Träger durch Impulsmodulationsverfahren aufgeprägt werden oder dadurch, daß die Trägerkompression für verschiedene Zustände des Nachrichtensignals in auswertbar unterschiedlicher Weise vorgenommen wird, so daß diese Variation der Winkelmodulation die Nachricht enthält. Wichtig ist hierbei, daß die Nachrichten-Modulation auf die Signallaufzeit ohne oder nur von untergeordnetem Einfluß ist.

Nach der Demodulation steht ein Signal mit einer erhöhten Momentanleistung zur Verfügung. Ein weiterer Vorteil des erfindungsgemäßen Verfahrens ist in dem wesentlich geringeren Störpotential gegenüber anderen Übertragungsstrecken zu sehen, da mit einer geringeren Sendeleistung ein vorgegebenes Signal/Rausch-Verhältnis nach der Impulskompression im Empfänger erreichbar ist. Darüber hinaus führen die geringeren Anforderungen an die Sendeleistung zu einer verringerten Human exposure. Der mit dem Verfahren verbundene Nachteil einer größeren benötigten Bandbreite und damit verringerten Kanalkapazität bzw. Übertragungsrate (Bitrate) kann für viele Anwendungsfälle in Kauf genommen werden und läßt sich durch Wahl eines angepaßten Pulsmodulationsverfahrens für die Nachrichten-Modulation teilweise eliminieren (siehe weiter unten).

Die Modulationskennlinie der Winkelmodulation - hier allgemein Modulationscharakteristik genannt - bestimmt hierbei den zeitlichen Verlauf der Frequenz jeweils während der Dauer eines Impulses. Bei Anwendung einer linear fallenden Modulationscharakteristik nimmt die Frequenz des übertragenen Signals jeweils während der Dauer eines Impulses von einem oberhalb der Trägerfrequenz liegenden Wert linear auf einen unterhalb der Trägerfrequenz liegenden Wert ab (Down Chirp). Analog ist ein linear steigende Kennlinie einsetzbar. Das empfängerseitige Filter ist der verwendeten Modulationscharakteristik durch ein entsprechendes differentielles frequenzabhängiges Laufzeitverhalten (Gruppenlaufzeitverhalten) in der Weise angepaßt, daß die senderseitig erzeugten Signalanteile unterschiedlicher Phasenlage zu einem zeitlich nahezu koinzidenten Signal (annähernden δ-Impuls) überlagert werden.

Die empfängerseitigen Filtermittel sind durch eine inverse bzw. komplementäre Kennlinie angepaßt. Erfolgt die senderseitige Winkelmodulation entsprechend einer fallenden Modulationscharakteristik, so nimmt die Frequenz des Impulses während der Impulsdauer ab, was zur Folge hat, daß die höherfrequenten Signalanteile empfängerseitig vor den niederfrequenten Signalanteilen erscheinen. Das Laufzeitverhalten des empfängerseitigen Dispersionsfilters muß diesen "Vorsprung" der höherfrequenten Signalanteile deshalb ausgleichen, damit sich die spektralen Signalanteile des frequenzmodulierten Impulses am Ausgang des Dispersionsfilters zu einem Impuls mit erhöhter Amplitude überlagern.

Es ist möglich, mehr als zwei Modulationscharakteristiken für das Eingangssignal zu verwenden, um mit jedem Impuls einen größeren Informationsanteil zu übertragen.

In der vorstehend beschriebenen Variante der Erfindung erfolgt die Modulation der Impulse aktiv sowohl für einen High-Pegel als auch für einen Low-Pegel des digitalen Eingangssignals. Dies bedeutet, daß sowohl bei einem High-Pegel als auch bei einem Low-Pegel des Eingangssignals frequenzmodulierte Impulse erzeugt werden, die sich durch die Art der Frequenzänderung während der Impulsdauer unterscheiden. Die Aufprägung der in dem Eingangssignal enthaltenen Nachricht auf das übertragene Signal erfolgt hierbei also durch die Auswahl bzw. Änderung der Modulationscharakteristik in Abhängigkeit vom Eingangssignal.

Alternativ kann die Übertragung des Eingangssignals bei nur einem von zwei definierten Pegeln aktiv vorgenommen werden, während bei dem anderen Pegel kein Impuls erzeugt wird. So wird beispielsweise bei einem High-Pegel des Eingangssignals ein linear ansteigend frequenzmodulierter Impuls erzeugt, während bei einem Low-Pegel eine Pause mit der Länge eines Impulses eingelegt wird. Diese Variante der Erfindung ermöglicht mit geringem technischen Aufwand eine Realisierung des Verfahrens mit einer einzigen Modulationscharakteristik. Insbesondere ist empfängerseitig auch nur ein Dispersionsfilter erforderlich.

Die Aufprägung der in dem Eingangssignal enthaltenen Nachricht auf das übertragene Signal erfolgt nach einem an sich bekannten digitalen Modulationsverfahren, vorzugsweise durch Pulspositionsmodulation (PPM - auch Pulsabstandsmodulation genannt), bei der die Lage der einzelnen frequenzmodulierten Impulse relativ zu einem Referenzimpuls in Abhängigkeit vom Eingangssignal geändert wird. Auch ein Einsatz der Pulsphasen- oder Pulsbreitenmodulation ist grundsätzlich sinnvoll, erfordert aber ggfs. einen höheren technischen Aufwand oder erreicht nicht alle Vorteile der PPM.

Bei der Kombination der "Chirp"-Modulation zur Träger-Störunterdrückung mit der PPM zur Aufprägung der Nachricht kann in besonders vorteilhafter Weise die mit der Impulskompression auf Impulse mir sehr kurzer Anstiegszeit einhergehende empfängerseitige Erhöhung der Zeitauflösung unter Ausnutzung des Superpositionsprinzips beim Empfang einander zeitlich überlappender Impulse zur Erhöhung der Übertragungsrate (bezogen auf die vergrößerte Bandbreite) genutzt werden. Insgesamt gesehen, gelingt damit eine weitgehende Kompensation der ursprünglichen Einbuße an Übertragungsrate. Ein (geringer) Teil der infolge der Kompression eingesparten Sendeleistung wird zu Ausendung der für die PPM benötigten Referenzimpulse und ggfs. zusätzlicher Codierungsimpulse im gleichen Kanal eingesetzt.

Die Rückgewinnung der in dem Eingangssignal enthaltenen Nachricht erfolgt durch einen dem Dispersionsfilter nachgeschalteten Detektor, der an das Modulationsverfahren angepaßt ist, das senderseitig zur Aufprägung der in dem Eingangssignal enthaltenen Nachricht verwendet wird.

Wird dagegen senderseitig in Abhängigkeit von der Amplitude des Eingangssignals eine von mehreren Modulationscharakteristiken ausgewählt, vorzugsweise eine linear fallende Modulationscharakteristik bei einem High-Pegel und eine linear steigende Modulationscharakteristik bei einem Low-Pegel des Eingangssignals, so bestehen zur Auswertung im Empfänger grundsätzlich zwei Möglichkeiten.

Eine Möglichkeit besteht darin, empfängerseitig nur ein Dispersionsfilter vorzusehen, dessen differentielles Phasenverzögerungs- bzw. Gruppenlaufzeitverhalten an eine der senderseitig verwendeten Modulationscharakteristiken in der Weise angepaßt ist, daß die Signalanteile des entsprechend dieser Modulationscharakteristik frequenzmodulierten Impulses am Ausgang des Dispersionsfilters überlagert erscheinen, was zu einer Impulskompression und Amplitudenerhöhung führt. Für einen Impuls mit einer der anderen Modulationscharakteristiken, die nicht optimal an das Laufzeitverhalten des empfängerseitigen Dispersionsfilters angepaßt ist, erscheinen die spektralen Signalanteile dagegen zeitlich verteilt am Ausgang des Dispersionsfilters und somit wegen der geringeren Impulskompression auch mit einer geringeren Amplitude. In dieser Ausführungsform hängt die Amplitude des am Ausgang des Dispersionsfilters erscheinenden Impulses also von der senderseitig verwendeten Modulationscharakteristik und damit von der Amplitude des Eingangssignals ab, die zur Auswahl der Modulationscharakteristik herangezogen wird. Um das digitale Eingangssignal aus dem Ausgangssignal des Dispersionsfilters zurückzugewinnen, ist diesem ein amplitudenempfindlicher Detektor nachgeschaltet, der als Amplitudendemodulator ausgeführt sein kann.

Die andere Möglichkeit sieht dagegen vor, den frequenzmodulierten Impuls empfängerseitig mehreren parallelgeschalteten Dispersionsfiltern zuzuführen. Das frequenzabhängige Laufzeitverhalten der empfängerseitig angeordneten Dispersionsfilter und die senderseitig verwendeten Modulationscharakteristiken sind hierbei jeweils paarweise derart aneinander angepaßt, daß die Signalanteile des frequenzmodulierten Impulses am Ausgang genau eines der Dispersionsfilter komprimiert erscheinen und dadurch zu einer Amplitudenerhöhung führen, während die Ausgangssignale der anderen Dispersionsfilter wegen der abweichenden Charakteristik nicht erhöht sind. Das Eingangssignal kann also danach diskriminiert werden, an welchem der Dispersionsfilter eine Amplitudenerhöhung vorliegt.

Die Dispersionsfilter werden vorteilhafterweise als Oberflächenwellenfilter ("SAW-Filter") ausgeführt, die sich mit hoher Genauigkeit und Stabilität herstellen lassen. Darüber hinaus bieten SAW-Filter den Vorteil, daß sich Amplitudengang und Phasengang unabhängig voneinander dimensionieren lassen, was die Möglichkeit eröffnet, das in jedem Empfänger erforderliche schmalbandige Bandpaßfilter und das Dispersionsfilter in einem Bauteil zu verwirklichen.

Die Erzeugung des frequenzmodulierten Signals im Sender kann auf verschiedene Arten erfolgen, von denen beispielhaft einige im folgenden kurz beschrieben werden.

Bei der Erfindung wird zunächst näherungsweise ein (Quasi-)Dirac-Impuls erzeugt und einem Tiefpaßfilter zugeführt, dessen Filterkennlinie kurz vor Erreichen der Grenzfrequenz eine Überhöhung aufweist und den Stoß-Impuls somit in einen si-Impuls (Spaltimpuls) transformiert, dessen Form durch -die bekannte si-Funktion si (x) =^{sinx}/ₓ beschrieben wird. Das si-förmige Ausgangssignal des Tiefpaßfilters wird anschließend auf einen Amplitudenmodulator gegeben, der der Trägerschwingung die si-förmige Hüllkurve aufprägt. Wird das auf diese Weise erzeugte Signal einem dispergierenden Filter zugeführt, so erscheint am Ausgang ein frequenzmodulierter Impuls. Hierbei erfolgt also senderseitig zunächst eine Expansion des relativ scharfen si-Impulses durch das Dispersionsfilter in einen frequenzmodulierten Impuls, der gegenüber dem si-Impuls verlängert ist und eine entsprechend geringere Amplitude aufweist. Empfängerseitig erfolgt dann ebenfalls durch ein Dispersionsfilter wieder eine Kompression des Impulses mit einer entsprechenden Amplitudenerhöhung. Da zur senderseitigen Expansion und empfängerseitigen Kompression der Impulse jeweils ein Dispersionsfilter verwendet wird, eignet sich die Erfindung vorteilhaft für einen Transceiverbetrieb mit abwechselndem Sende- und Empfangsbetrieb. Hierzu können Sender und Empfänger jeweils korrespondierende baugleiche Baugruppen mit jeweils einem Dispersionsfilter aufweisen, die im Sendebetrieb zur Erzeugung des frequenzmodulierten Impulses und im Empfangsbetrieb zur Kompression der empfangenen frequenzmodulierten Impulse dienen.

Gemäß einer anderen Variante der Erfindung erfolgt die Erzeugung des frequenzmodulierten Impulses dagegen mittels einer PLL-Schleife (PLL: Phase Locked Loop) und einem spannungsgesteuerten Oszillator (VCO: Voltage Controlled Oscillator). Die einzelnen Impulse des in digitaler Form vorliegenden Eingangssignals werden hierzu zunächst in einem Integrator in sägezahnförmige Impulse umgewandelt, wobei die Anstiegsrichtung der einzelnen Impulse von der Amplitude des Eingangssignals abhängt. Das auf diese Weise erzeugte Signal wird dann zur Ansteuerung des VCO's verwendet, so daß die Frequenz eines Ausgangsimpulses während der Impulsdauer in Abhängigkeit vom Pegel des Eingangssignals linear zunimmt oder fällt.

In einer weiteren Variante der Erfindung erfolgt die Erzeugung des frequenzmodulierten Impulses im Sender durch eine digitale Signalverarbeitungseinheit, was vorteilhaft die Realisierung beliebiger Modulationscharakteristiken ermöglicht.

In einer Variante der Erfindung werden zur Realisierung der komplementären Sender-Empfänger-Charakteristik jeweils aneinander angepaßte Sender-Empfänger-Paare hergestellt, so daß bei der Inbetriebnahme keine weiteren Abstimmarbeiten erforderlich sind.

In einer anderen Variante der Erfindung wird der Empfänger dagegen vor oder während des Betriebs durch Veränderung des Laufzeitverhaltens des empfängerseitig verwendeten Dispersionsfilters an den Sender angepaßt. Hierfür ist vorgesehen, daß der Sender im Rahmen eines Anpassungsvorgangs ein Referenzsignal erzeugt, das vorzugsweise einer Folge von High-Pegeln des Eingangssignals entspricht, wobei die Modulationscharakteristik der senderseitig vorgenommenen Frequenzmodulation oder das frequenzabhängige Laufzeitverhalten des empfängerseitigen Dispersionsfilters so lange verändert wird, bis empfängerseitig eine optimale Impulskompression bzw. Amplitudenerhöhung auftritt. Besonders vorteilhaft ist diese Variante bei der Verwendung eines digitalen Signalprozessors zur Filterung und Aufbereitung im Empfänger, da ein derartiger Signalprozessor in einfacher Weise eine Änderung des frequenzabhängigen Laufzeitverhaltens und eine entsprechende Optimierung ermöglicht, wobei der Optimierungsvorgang rechnergesteuert automatisch ablaufen kann.

In einer weiteren vorteilhaften Ausführungsform dieser Variante erfolgt die Datenübertragung blockweise, wobei der vorstehend beschriebene Anpassungsvorgang bei jedem Block erneut durchgeführt wird, um Schwankungen der Dispersionseigenschaften der Übertragungsstrecke dynamisch ausgleichen zu können.

Vorteilhafte Weiterbildungen der Erfindung sind im übrigen in den Unteransprüchen gekennzeichnet bzw. werden nachstehend zusammen mit der Beschreibung der bevorzugten Ausführung der Erfindung anhand der Figuren näher dargestellt. Es zeigen:
- Figur 1a, 1b: als bevorzugtes Ausführungsbeispiel der Erfindung einen Sender bzw. einen Empfänger eines Nachrichtenübertragungssystems als Blockschaltbild,
- Figur 2a bis 2e: das digitale Eingangssignal des Senders sowie verschiedene Zwischenstadien der Signalverarbeitung im Sender bis zum Sendesignal sowie
- Figur 3a bis 3d: das Empfangssignal sowie verschiedene Zwischenstadien der Signalverarbeitung im Empfänger bis zum demodulierten Signal,
- Figur 4a, 4b: Sender bzw. Empfänger eines Nachrichtenübertragungssystems mit aktiver Übertragung von High- und Low-Pegel in einer Darstellung als Blockschaltbild,
- Figur 5a bis 5k: das digitale Eingangssignal des Senders in Figur 4a sowie verschiedene Zwischenstadien der Signalverarbeitung im Sender,
- Figur 6a bis 6e: das empfängerseitig aufgenommene Signal sowie mehrere Zwischenstadien der Signalverarbeitung im Empfänger,
- Figur 7, 8: jeweils eine abgewandelte Form des in Figur 4b dargestellten Empfängers mit einer Rauschunterdrückungsschaltung und
- Figur 9a und 9b: grafische Darstellungen zur mit dem erfindungsgemäßen Verfahren erzielbaren Verbesserung des Signal/Rausch-Verhältnisses.

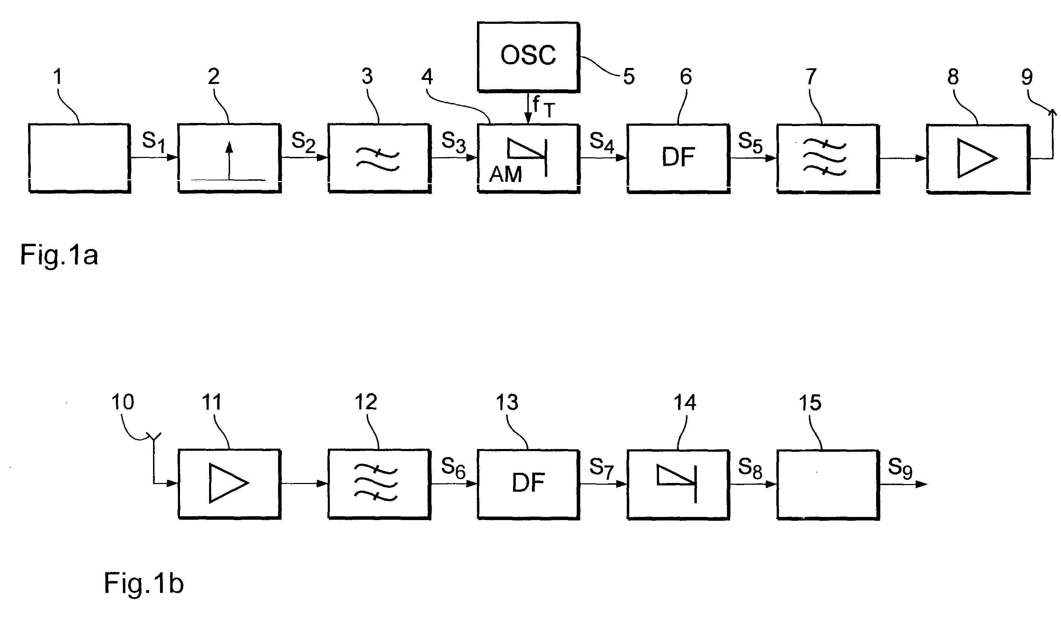

Ein in Figur 1a dargestellter Sender dient zur Übertragung des von einer Signalquelle 1 erzeugten und in digitalisierter Form vorliegenden Signals s₁ über eine störungsbehaftete Übertragungsstrecke an den in Figur 1b dargestellten Empfänger, wobei die Übertragung bei vorgegebenen Anforderungen an Reichweite und Störsicherheit vorteilhaft mit einer relativ geringen Sendeleistung erfolgen kann, was zum einen bei einem Batteriebetrieb des Senders die Batterielebensdauer erhöht und zum anderen die Umweltbelastung durch elektromagnetische Strahlung - auch als Elektro-Smog bezeichnet - verringert. Darüber hinaus weist der Sender aufgrund der relativ geringen Sendeleistung ein verringertes Störpotential anderen Nachrichtenübertragungssystemen gegenüber auf.

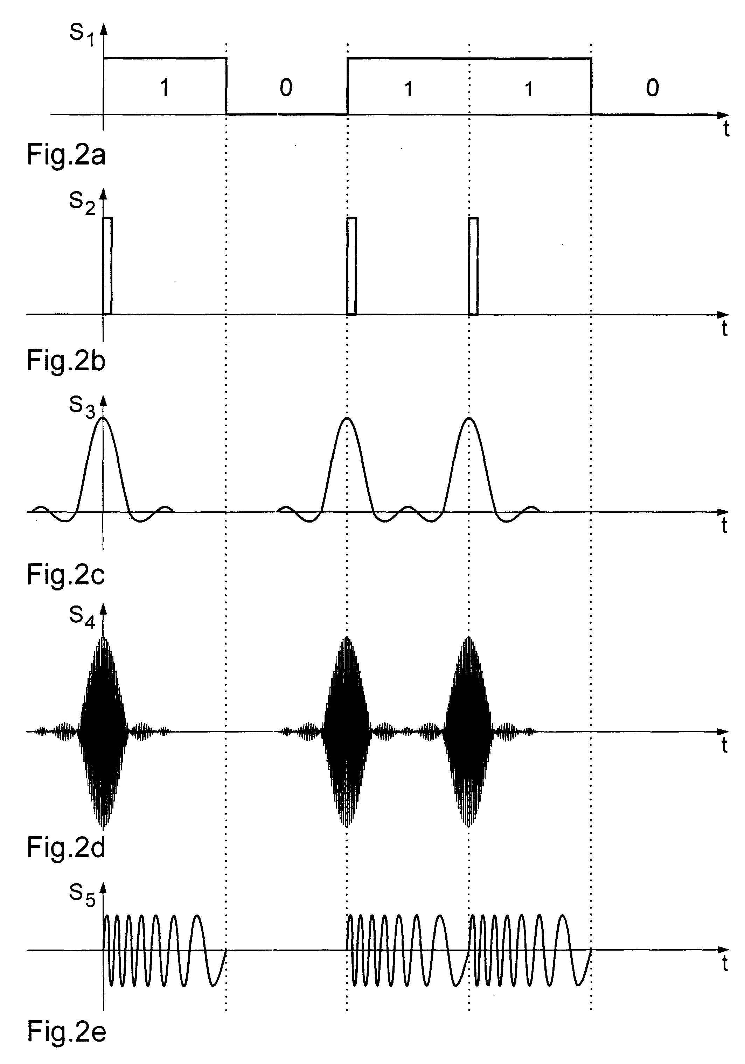

Ein digitales Eingangssignal s₁, dessen zeitlicher Verlauf in Figur 2a detailliert dargestellt ist, wird im Sender zunächst einem Pulsformer 2 zugeführt, der die relativ breiten Rechteckimpulse des Eingangssignals s₁ in kurze Nadelimpulse transformiert, die (quasi-)Dirac-Impulse nachbilden sollen. Aus der Darstellung der Nadelimpulsfolge s₂ in Figur 2b ist ersichtlich, daß die Erzeugung der einzelnen Nadelimpulse jeweils durch die steigende Flanke eines Rechteckimpulses des Eingangssignals s₁ getriggert wird.

Ein auf diese Weise erzeugte Nadelimpulsfolge s₂ wird anschließend einem Tiefpaßfilter 3 zugeführt, dessen Laufzeitverhalten kurz vor der Grenzfrequenz eine Überhöhung aufweist, so daß die einzelnen Nadelimpulse - wie aus Figur 2c ersichtlich - jeweils in si-Impulse transformiert werden, deren Form der bekannten si-Funktion (Spaltfunktion) si(x)=^{sin x}/ₓ entspricht.

Im Anschluß daran wird die si-Impulsfolge s₃ einem Amplitudenmodulator 4 zugeführt, der dieses Signal auf eine Trägerschwingung der Frequenz f_{T} aufmoduliert, die von dem Oszillator 5 erzeugt wird, so daß am Ausgang des Amplitudenmodulators 4 - wie in Figur 2d dargestellt - Trägerfrequenzimpulse mit einer si-förmigen Hüllkurve erzeugt werden. (Die Impulse sind in der Zeichnung aus darstellungstechnischen Gründen verbreitert dargestellt, sind also - bei maßstäblicher Darstellung - tatsächlich schmaler.)

Dem Amplitudenmodulator 4 ist ein Dispersionsfilter 6 nachgeschaltet, welches das modulierte Trägerfrequenzsignal s₄ entsprechend seiner frequenzabhängigen differentiellen Laufzeitcharakteristiken filtert. Am Ausgang des Dispersionsfilters 6 erscheinen deshalb - wie aus Figur 2e ersichtlich - linear frequenzmodulierte Impulse mit konstanter Amplitude, deren Frequenz während der Impulsdauer von einem oberhalb der Trägerfrequenz f_{T} liegenden Wert f_{T}+Δf/2 auf einen unterhalb der Trägerfrequenz f_{T} liegenden Wert f_{T}-Δf/2 abfällt.

Bei dem hier dargestellten Sender erfolgt die Übertragung des Eingangssignals s₁ also unipolar, d.h. es wird lediglich bei einem High-Pegel des Eingangssignals s₁ ein Sendeimpuls erzeugt, während ein Low-Pegel an einer Pause des Sendesignals s₅ erkennbar ist. Aus diesem Grund lassen sich Sender und Empfänger vorteilhaft relativ einfach mit jeweils nur einem Dispersionsfilter 6 bzw. 13 aufbauen.

Die auf diese Weise erzeugte Impulsfolge s₅ wird nachfolgend einem Bandpaßfilter 7 zugeführt, dessen Mittenfrequenz gleich der Trägerfrequenz f_{T} der frequenzmodulierten Impulse ist, so daß außerhalb des Übertragungsbandes liegende Signale ausgefiltert werden.

Das bandpaßbegrenzte Signal wird schließlich über einen Sendeverstärker 8 der Antenne 9 zugeführt und abgestrahlt.

Der in Figur 1b dargestellte Empfänger ermöglicht den Empfang des von dem vorstehend beschriebenen Sender abgestrahlten linear frequenzmodulierten Signals sowie die Demodulation und Rückgewinnung des digitalen Eingangssignals s₃ bzw. s₁.

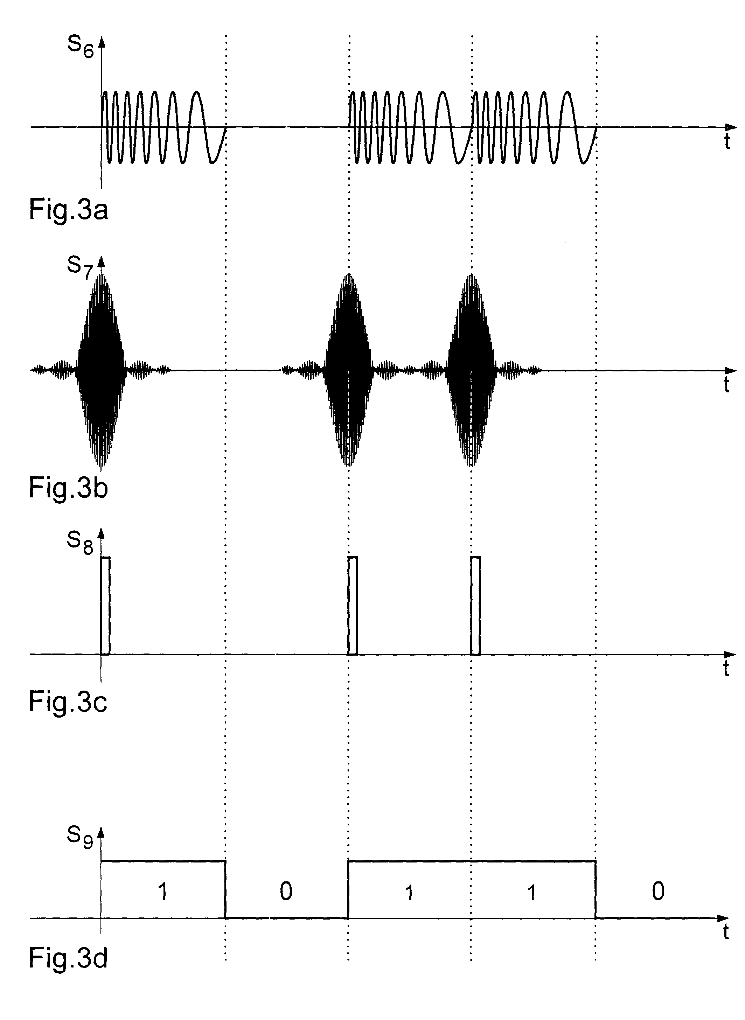

Hierzu wird bei dem vorliegenden Ausführungsbeispiel das über die Empfängerantenne 10 - beispielsweise auch im Diversity-Betrieb - empfangene Signal zunächst einem Vorverstärker 11 und nachfolgend einem Bandpaßfilter 12 zugeführt, dessen Mittenfrequenz gleich der Trägerfrequenz f_{T} des bandpaßbegrenzten Sendesignals ist, so daß Störsignale aus anderen Frequenzbereichen aus dem empfangenen Signal ausgefiltert werden. (Anstelle eines konventionellen Bandpaßfilters kann hier auch vorteilhafterweise ein SAW-Filter verwendet werden.) Der zeitliche Verlauf des auf diese Weise aufbereiteten Signals s₆ ist detailliert in Figur 3a dargestellt, wobei zur Vereinfachung eine störungsfreie Übertragungsstrecke angenommen wird.

Das empfangene Signal s₆ besteht also aus einer Folge von linear frequenzmodulierten Impulsen, wobei die Frequenz entsprechend der senderseitig verwendeten Modulationscharakteristik während der Impulsdauer linear von einem oberhalb der Trägerfrequenz liegenden Wert f_{T}+Δf/2 auf einen unterhalb der Trägerfrequenz f_{T} liegenden Wert f_{T}-Δf/2 abfällt.

Das Signal s₆ wird anschießend einem Dispersionsfilter 13 zugeführt, das die einzelnen Impulse des Eingangssignals s₆ zeitlich komprimiert, was zu einer entsprechenden Amplitudenerhöhung und damit einem verbesserten Signal/Rauschabstand führt.

Die Impulskompression nutzt hierbei die Tatsache, daß die höherfrequenten Signalanteile der Impulse aufgrund der senderseitig durchgeführten linearen Frequenzmodulation am Eingang des Dispersionsfilters 13 vor den niederfrequenten Signalanteilen erscheinen. Das Dispersionsfilter 13 gleicht deshalb den "Vorsprung" der höherfrequenten Signalanteile aus, indem diese in dem Dispersionsfilter stärker verzögert werden als die niederfrequenten Signalanteile. Das frequenzabhängige differentielle Laufzeitverhalten des Dispersionsfilters 13 ist hierbei derart an die Modulationscharakteristik der senderseitig durchgeführten Frequenzmodulation angepaßt, daß die spektralen Signalanteile des empfangenen Signals im wesentlichen koinzident am Ausgang des Dispersionsfilters 13 erscheinen und sich somit - wie aus Figur 3b ersichtlich - zu einem Signal s₇ mit jeweils impulsweise si-förmiger Hüllkurve überlagern, wobei die Amplitude der einzelnen Impulse gegenüber dem empfangenen linear frequenzmodulierten Signal s₆ wesentlich vergrößert ist. (An dieser Stelle ist darauf hinzuweisen, daß bei den in den Figuren dargestellten prinzipiellen Signaldarstellungen zur Vergrößerung der Deutlichkeit eine Verzerrung vorgenommen wurde. Die linear frequenzmodulierten Impulse sind in der Realität im Verlauf enger und die komprimierten Signale sehr viel schmaler.

Das Ausgangssignal des Dispersionsfilters 13 wird dann einem Demodulator 14 zugeführt, der das Signal S₇ von der hochfrequenten Trägerschwingung befreit und - wie aus Figur 3c ersichtlich - ein diskretes Ausgangssignal s₈ mit nadelförmigen Impulsen erzeugt.

Im Anschluß daran wird aus den nadelförmigen Impulsen mittels eines Impulsformers 15 das ursprüngliche digitale Signal s₉ zurückgewonnen, dessen zeitlicher Verlauf detailliert in Figur 3d dargestellt ist.

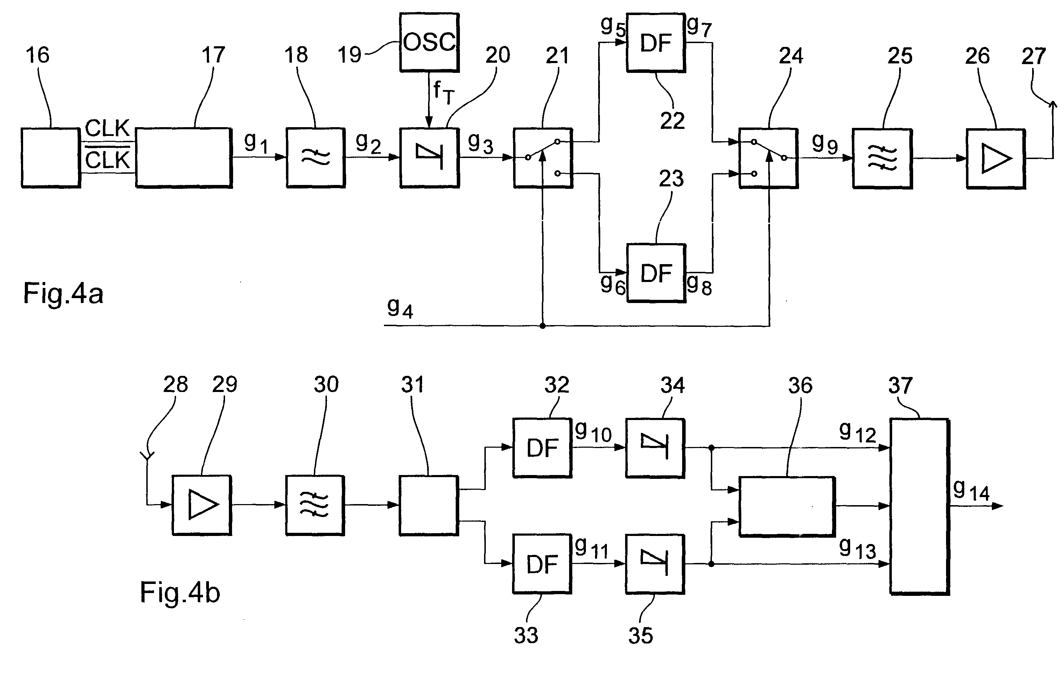

In den Figuren 4a und 4b ist ein weiteres erfindungsgemäß ausgestaltetes Nachrichtenübertragungssystem dargestellt, das sich von dem vorstehend beschriebenen einfacheren Ausführungsbeispiel im wesentlichen dadurch unterscheidet, daß sowohl der High-Pegel als auch der Low-Pegel des digitalen Nachrichtensignals aktiv übertragen wird, was zu einer erhöhten Störsicherheit beiträgt.

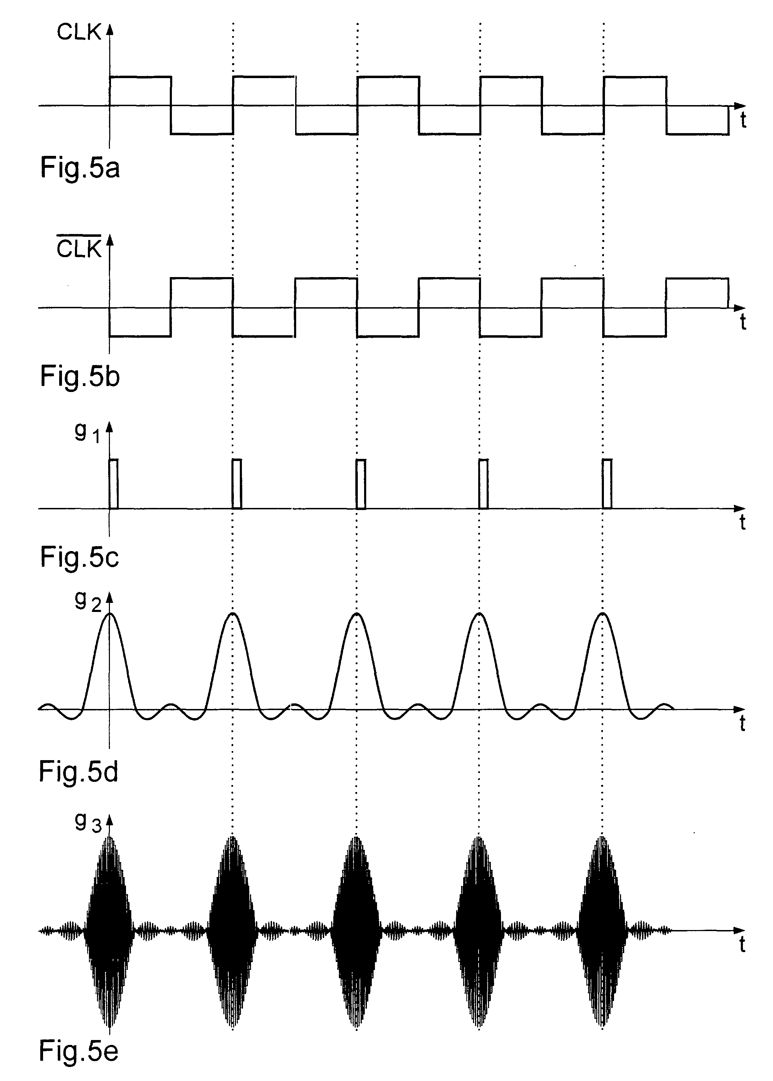

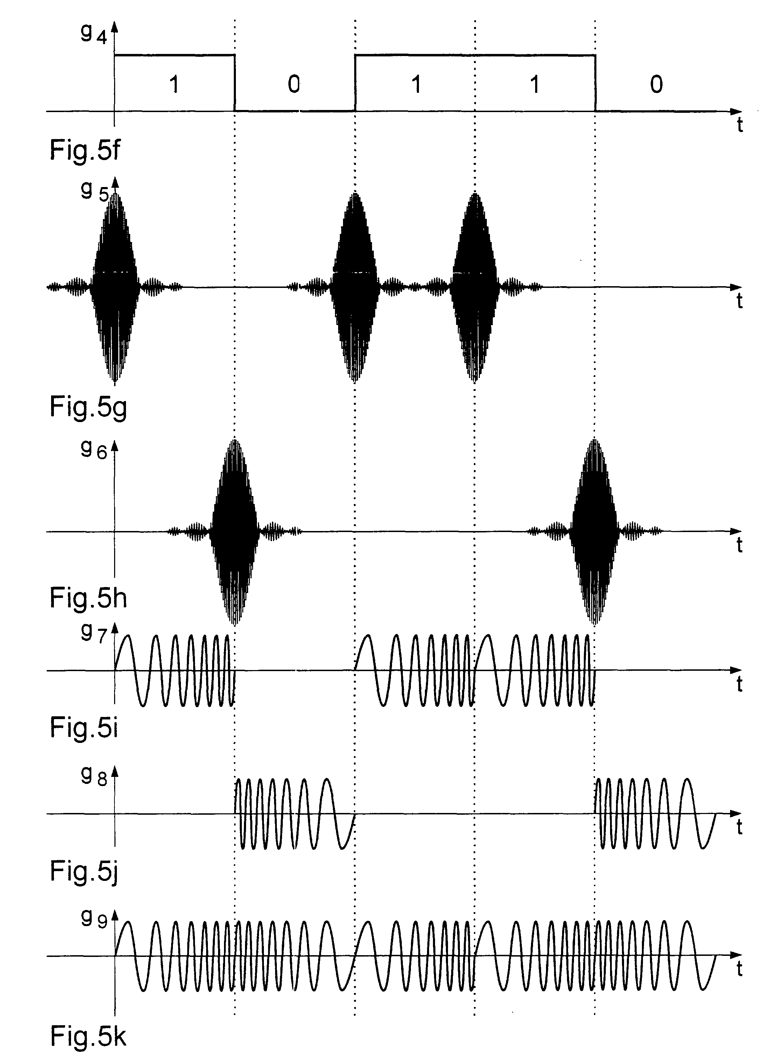

Der in Figur 4a dargestellte Sender weist hierzu einen Pulsformer 17 auf, der von einem Taktgeber 16 mit den in Figur 5a bzw. 5b dargestellten gegenphasigen Taktsignalen angesteuert wird und an seinem Ausgang - wie in Figur 5c dargestellt - eine Folge g₁ von nadelförmigen Impulsen ausgibt, die eine (Quasi-)Dirac-Stoß-Folge nachbilden. Die auf diese Weise erzeugte Impulsfolge g₁ wird anschließend einem Tiefpaßfilter 18 zugeführt, dessen Filterkennlinie kurz vor der Grenzfrequenz eine Überhöhung aufweist und die nadelförmigen Impulse jeweils in si-förmige Impulse (Spaltimpulse) transformiert, die detailliert in Figur 5d dargestellt sind. Nachfolgend wird diese Impulsfolge g₂ mittels eines Amplitudenmodulators 20 auf eine von dem Oszillator 19 erzeugte Trägerschwingung mit der Trägerfrequenz f_{T} aufmoduliert. Am Ausgang des Amplitudenmodulators 20 erscheint somit eine Folge g₃ von äquidistanten Trägerfrequenzimpulsen mit jeweils si-förmiger Hüllkurve. Wichtig ist in diesem Zusammenhang, daß die am Ausgang des Amplitudenmodulators 20 erscheinende Impulsfolge g₃ unabhängig von dem digitalen Eingangssignal g₄ ist und somit keine Information trägt.

Die Aufprägung der Information des Eingangssignals g₄ erfolgt anschließend mittels eines Analog-Schalters 21, der von dem Eingangssignal g₄ angesteuert wird und die von dem Amplitudenmodulator 20 erzeugte Impulsfolge g₃ in Abhängigkeit von der Amplitude des Eingangssignals g₄ entweder einem Dispersionsfilter 22 mit einer frequenzabhängig linear fallenden Laufzeit oder einem Dispersionsfilter 23 mit einer frequenzabhängig linear steigenden Laufzeit zuführt. Ausgangsseitig sind die beiden Dispersionsfilter 22, 23 mit einem weiteren Analog-Schalter 24 oder einer Summierstufe verbunden, der in Abhängigkeit von der Amplitude des Eingangssignals g₄ das Ausgangssignal g₇ bzw. g₈ eines der beiden Dispersionsfilter 22, 23 auswählt und weiterleitet.

Am Ausgang des Analog-Schalters 24 erscheint somit - wie in Figur 5k dargestellt - eine Folge g₉ von jeweils impulsweise linear frequenzmodulierten Trägerfrequenzimpulsen, wobei die einzelnen Impulse bei einem High-Pegel des Eingangssignals g₄ innerhalb der Impulsdauer eine linear zunehmende Frequenz aufweisen, wohingegen bei einem Low-Pegel des Eingangssignals g₄ die Frequenz innerhalb eines Impulses linear abnimmt.

Das am Ausgang des Analog-Schalters 24 erscheinende Signal wird anschließend von einem Bandpaßfilter 25 gefiltert, um außerhalb des Übertragungsbandes liegende Störsignale zu unterdrücken. Das auf diese Weise gewonnene Signal wird dann von einem Sendeverstärker 26 verstärkt und über die Sendeantenne 27 abgestrahlt.

Figur 4b zeigt den zugehörigen Empfänger, der das von dem in Figur 4a dargestellten Sender abgestrahlte Signal über eine Antenne 28 empfängt und zunächst in einem Vorverstärker 29 verstärkt und in einem Bandpaßfilter 30 von solchen Störsignalen befreit, deren Frequenz außerhalb des Übertragungsbandes liegt.

Anschließend wird das empfangene Signal über ein Koppelelement 31 zwei Dispersionsfiltern 32, 33 zugeführt. Das frequenzabhängige Laufzeitverhalten der beiden empfängerseitigen Dispersionsfilter 32, 33 ist hierbei jeweils paarweise an das frequenzabhängige Laufzeitverhalten der beiden senderseitig angeordneten Dispersionsfilter 22, 23 in der Weise angepaßt, daß sich die spektralen Signalanteile des empfangenen Signals am Ausgang eines der beiden Dispersionsfilter 32 bzw. 33 zu einem Impuls mit erhöhter Amplitude addieren, während am Ausgang des anderen Dispersionsfilters 33 bzw. 32 ein zeitlich expandierter Impuls erscheint.

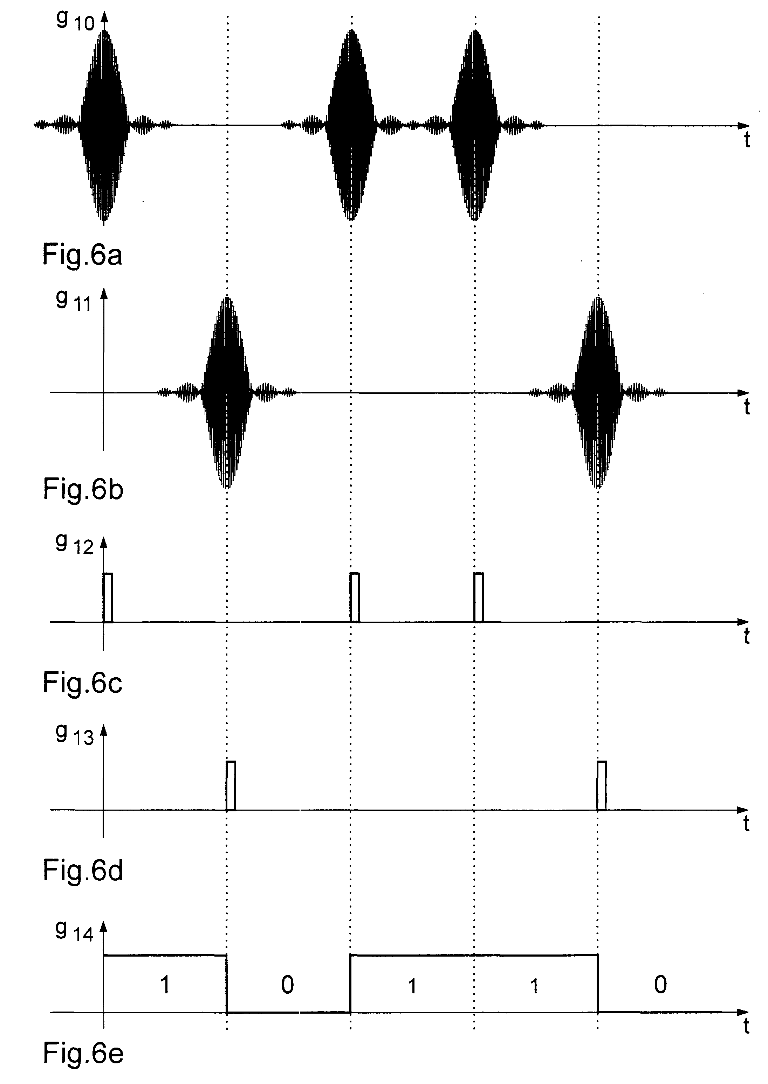

Aus den Figuren 6a und 6b ist ersichtlich, daß die Ausgangssignale g₁₀ bzw. g₁₁ der Dispersionsfilter 32, 33 jeweils aus einer Folge von Trägerfrequenzimpulsen mit einer si-förmigen Hüllkurve bestehen.

Die am Ausgang der beiden Dispersionsfilter 32, 33 erscheinenden Signale g₁₀ bzw. g₁₁ werden anschließend jeweils einem Demodulator 34, 35 zugeführt, der die Signale g₁₀ bzw. g₁₁ von der Trägerschwingung befreit und jeweils nadelförmige Impulse erzeugt, wie aus Figur 6c bzw. 6d ersichtlich.

Während die Nadelimpulse am Ausgang des einen Demodulators 34 jeweils einem High-Pegel des Eingangssignals g₄ entsprechen, kennzeichnen die am Ausgang des anderen Demodulators 35 erscheinenden Nadelimpulse jeweils einen Low-Pegel des Eingangssignals g₄.

Um aus diesen beiden Signalen g₁₂, g₁₃ das ursprüngliche Eingangssignal g₄ zurückzugewinnen, werden die beiden Signale g₁₂, g₁₃ zur Triggerung einem Taktgeber 36 zugeführt, der ein Taktsignal erzeugt, welches die Taktrate des ursprünglichen Eingangssignals g₄ wiedergibt. Dieses Taktsignal wird zusammen mit den Ausgangssignalen g₁₂, g₁₃ der beiden Demodulatoren 34, 35 dem Dekoder 37 zugeführt, der das ursprüngliche Ausgangssignale g₄ bzw. g₁₄ zurückgewinnt, wie aus Figur 6e ersichtlich ist.

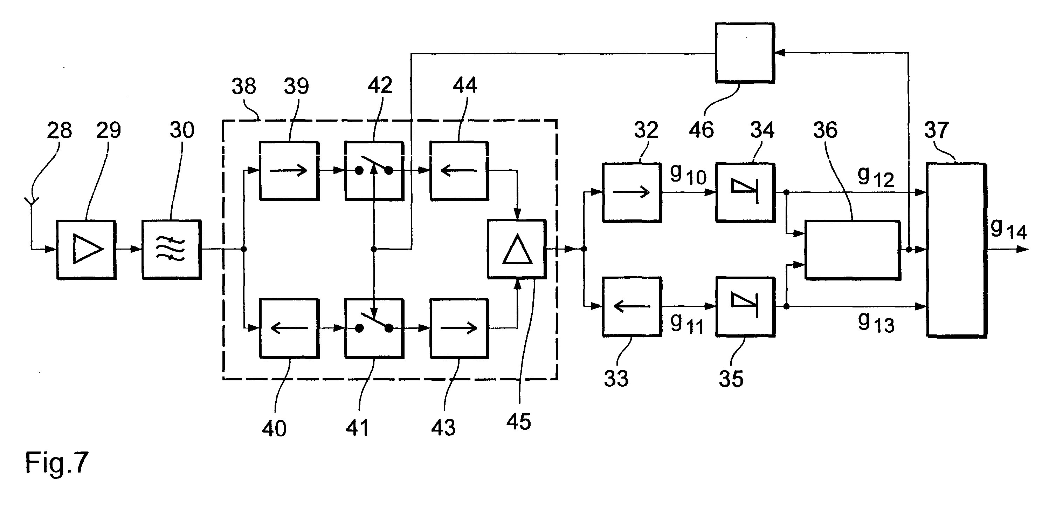

Figur 7 zeigt eine abgewandelte Form des in Figur 4b dargestellten Empfängers mit einer Rauschunterdrückungsschaltung 38, die auch mit anderen Empfängern für derartige Chirp-Signale kombiniert werden kann. Wegen der weitgehenden Übereinstimmung dieses Empfängers mit dem in Figur 4b dargestellten Empfänger sind funktionsgleiche Bauelemente in beiden Figuren mit denselben Bezugszeichen versehen.

Wie bei dem bereits vorstehend beschriebenen Empfänger wird das senderseitig gechirpte Signal über die Antenne 28 aufgenommen und zunächst einem Eingangsverstärker 29 sowie einem Bandpaßfilter 30 zugeführt, das auf die Trägerfrequenz abgestimmt ist und somit außerhalb des Übertragungsbandes liegende Störsignale ausfiltert. Anschließend wird das Signal der Rauschunterdrückungsschaltung 38 zugeführt und von dieser zunächst auf zwei parallele Zweige aufgeteilt, in denen jeweils zwei zueinander inverse Dispersionsfilter 39, 44 bzw. 40, 43 in Reihe geschaltet sind. Bei einer aktiven Übertragung sowohl eines logischen LOW-Pegels als auch eines logischen HIGH-Pegels ist also eines der beiden eingangsseitig angeordneten Dispersionsfilter 39 bzw. 40 derart angepaßt, daß am Ausgang dieses Dispersionsfilters 39 bzw. 40 ein zeitlich komprimierter Impuls erscheint. Am Ausgang des anderen Dispersionsfilters 40 bzw. 39 erscheint dagegen ein auf die doppelte Länge zeitlich expandierter Impuls. Die beiden Analogschalter 41, 42 unterbrechen jedoch den Signalfluß in den beiden Zweigen symmetrisch um die Mitte des komprimierten Impulses, so daß der zeitlich komprimierte Impuls unterdrückt wird und lediglich der zeitlich expandierte Impuls im anderen Zweig übrig bleibt. Die Ansteuerung der Analogschalter 41, 42 erfolgt hierbei durch die Synchrcnsierungsschaltung 46, die von dem Taktgeber 36 angesteuert wird und somit den Takt des Ausgangssignals und damit den Übertragungstakt vorgibt. Die nachfolgenden Dispersionsfilter 43, 44 erzeugen aus dem zeitlich expandierten Impuls dann wieder den ursprünglichen Impuls mit der ursprünglichen Länge und entsprechend auch mit der ursprünglichen Amplitude. Diese Impulse werden dann auf den Subtrahierer 45 geleitet, an dessen Ausgang somit im wesentlichen der ursprüngliche Impuls erscheint.

Anders liegen die Verhältnisse dagegen bei dem Rauschen, das durch die störungsbehaftete Übertragungsstrecke verursacht wird und zusammen mit dem Nutzsignal vom Empfänger aufgenommen wird. Dieses Rauschen wird zunächst durch die Dispersionsfilter 39, 40 in unterschiedlicher Richtung verschoben. Die nachgeschalteten Dispersionsfilter 43, 44 machen diese Verschiebung jedoch wieder rückgängig, so daß das Eingangsrauschen in den beiden Zweigen bis auf den sehr kurzen, von den Analogschaltern 41, 42 ausgeschnittenen Teil rekonstruiert wird. Die Differenzbildung durch den Subtrahierer 45 führt deshalb zu einer nahezu weitgehenden Unterdrückung des empfängerseitig aufgenommenen Rauschens.

Die weitere Verarbeitung des derart aufbereiteten Signals erfolgt dann wie in der Beschreibung zu Figur 4b ausgeführt.

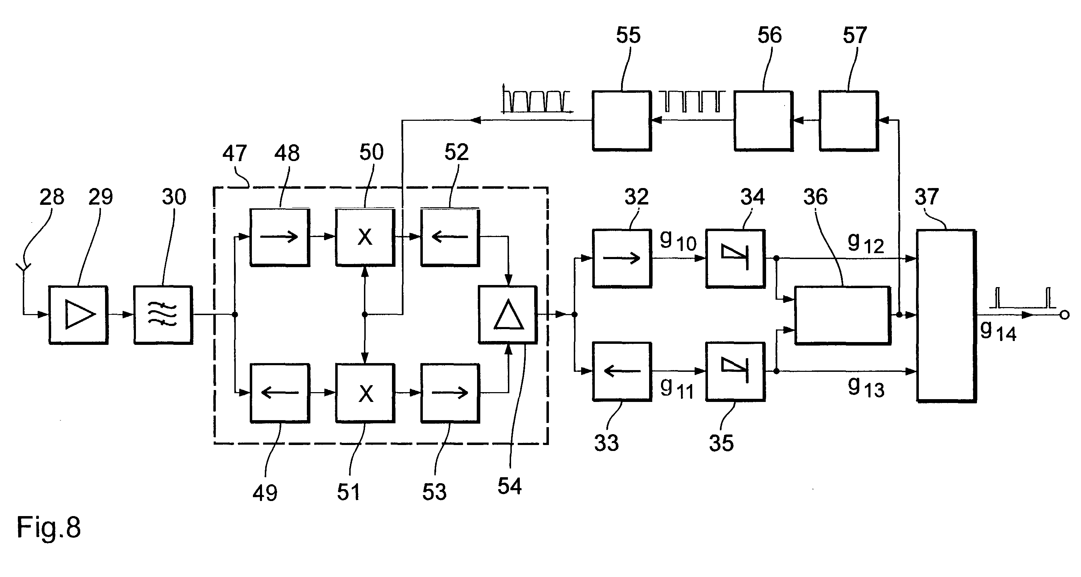

Der in Figur 8 dargestellte Empfänger unterscheidet sich von dem vorstehend beschriebenen und in Figur 7 dargestellten Empfänger im wesentlichen durch den Aufbau und die Ansteuerung der Rauschunterdrückungsschaltung 47. Wegen der somit vorhanden weitgehenden Übereinstimmung der beiden Schaltungen sind funktionsgleiche Bauelemente bzw. Baugruppen in Figur 7 und 8 durch dieselben Bezugszeichen gekennzeichnet.

Wie auch bei dem in Figur 7 dargestellten Empfänger werden die gechirpten Impulse über die Antenne 28 aufgenommen und zunächst einem Eingangsverstärker 29 und einem Bandpaßfilter 30 zugeführt, das auf die Trägerfrequenz abgestimmt ist und somit außerhalb des Übertragungsbandes liegende Störsignale ausfiltert.

Anschließend wird das Signal der Rauschunterdrückungsschaltung 47 zugeführt, die das Signal zunächst auf zwei parallele Zweige aufteilt, in denen jeweils zwei zueinander inverse Dispersionsfilter 48, 52 bzw. 49, 53 in Reihe geschaltet angeordnet sind. Am Ausgang der Rauschunterdrükkungsschaltung 47 werden die beiden Zweige von dem Subtrahierer 54 zusammengeführt, wodurch das Rauschen in dem empfangenen Signal aufgrund der Differenzbildung nahezu vollständig unterdrückt wird.

Im Gegensatz dazu wird das gechirpte Signal durch die Differenzbildung im Subtrahierer 54 nicht aufgehoben, so daß sich der Signal/Rauschabstand wesentlich erhöht. Die eingangsseitig angeordneten Dispersionsfilter 48, 49 sind hierbei derart an die senderseitig erzeugten gechirpten Signale angepaßt, daß am Ausgang eines der Dispersionsfilter 48, 49 ein zeitlich komprimierter Impuls mit entsprechend erhöhter Amplitude erscheint, während am Ausgang des anderen Dispersionsfilters 49, 48 ein zeitlich expandierter Impuls mit entsprechend verringerter Amplitude erscheint. Der Signalfluß in den beiden Zweigen wird nun jeweils beim Erscheinen des komprimierten Impulses - wie noch detailliert beschrieben wird -- durch die Multiplizierer 50, 51 synchron unterbrochen, so daß der komprimierte Impuls unterdrückt wird und lediglich der zeitlich expandierte Impuls bis auf die vernachlässigbare kurzfristige Ausschneidung erhalten bleibt. Durch die nachgeschalteten Dispersionsfilter 52, 53 wird dann aus dem zeitlich expandierten Impuls wieder der ursprüngliche Impuls erzeugt, so daß am Ausgang des Subtrahierers 54 im wesentlichen das ursprünglich empfangene Signal mit einem wesentlich verbesserten Signal/Rauschabstand erscheint.

Die Ansteuerung der Multiplizierer 50, 51 erfolgt in fester Synchronisation zum Übertragungstakt, um das Signal in den beiden Zweigen der Rauschunterdrückungsschaltung 47 jeweils exakt beim Erscheinen des zeitlich komprimierten Impuls unterdrücken zu können. Hierzu weist der Empfänger eine Synchronisationsschaltung 57 auf, die eingangsseitig zur Synchronisation mit dem Taktgeber 36 verbunden ist. Über einen nachgeschalteten Pulsformer 56 und ein Tiefpaßfilter 55 werden dann invertierte, mit der Spitze zu Null liegende Spaltimpulse mit der Amplitude 1 erzeugt, die den Multiplizierern 50, 51 zugeführt werden. Die Multiplizierer 50, 51 multiplizieren die Signale in den beiden Zweigen der Rauschunterdrückungsschaltung 47 also entweder mit Null oder mit Eins, was entsprechend entweder zu einer Unterdrückung des Signals führt oder das Signal im wesentlichen unverändert passieren läßt. Die Multiplizierer 50, 51 haben hier also die gleiche Wirkung wie die Schaltelemente 41, 42 in der zuvor beschriebenen Variante der Rauschunterdrükkungsschaltung 38.

Die Erfindung beschränkt sich in ihrer Ausführung nicht auf die vorstehend angegebenen bevorzugten Ausführungsbeispiele. Vielmehr ist eine Anzahl von Varianten möglich, welche von der dargestellten Lösung auch bei grundsätzlich anders gearteten Ausführungen Gebrauch macht. Die hier dargestellten Ausführungsbeispiele sind dabei lediglich als Grundformen eines breiten Spektrums von Lösungen anzusehen.

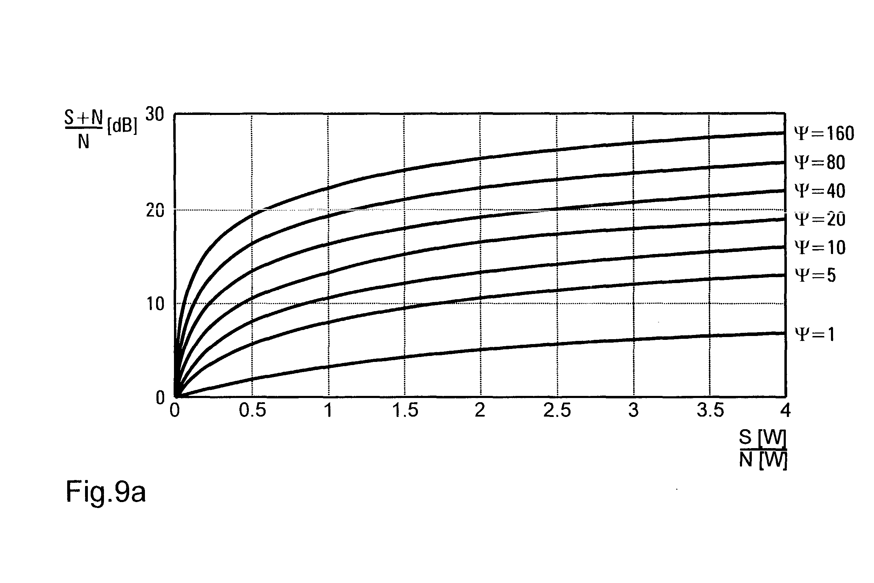

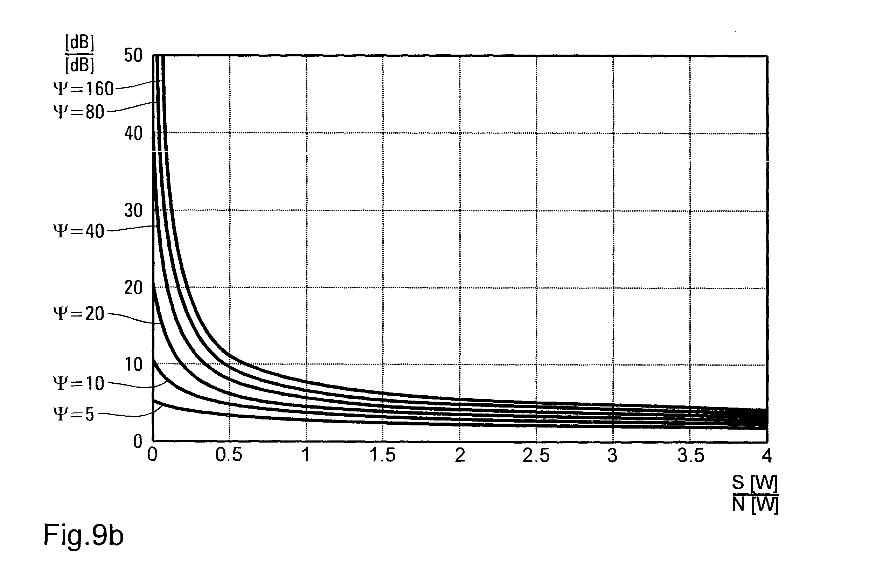

Die Figuren 9a und 9b illustrieren die mit der Erfindung erzielbare Verbesserung des Signal/Rausch-Verhältnisses für verschiedene Dehnungsfaktoren ψ = T_{T}/δ mit T_{T} als mittlerer Zeitdauer eines mittels des "Chirp"-Verfahrens bearbeiteten Sendeimpulses und δ als mittlerer Zeitdauer des im Empfänger komprimierten Impulses. Fig. 9a stellt die Abhängigkeit des Signal/Rausch-Verhältnisses (S+N)/N am Empfängerausgang von S/N am Empfängereingang und Fig. 9b die Abhängigkeit der auf ψ = 1 normierten Abhängigkeiten (S+N)/N = f(S/N) - d.h. den Grad der Verbesserung in Abhängigkeit vom ursprünglichen Signal/Rausch-Verhältnis - dar, wobei für ψ jeweils Werte im Bereich von 1 bis 160 als Parameter gewählt sind.

Die Figuren verdeutlichen, daß die erreichbare Verbesserung mit zunehmender Impuls"dehnung"/-kompression größer wird und für kleine ursprüngliche Signal/Rauschabstände besonders deutlich ausfällt. Dies dokumentiert nachdrücklich, daß das Verfahren besonders in stark gestörten Umgebungen und/oder bei großen Übertragungsreichweiten und/oder für geringe Sendeleistungen vorteilhaft einsetzbar ist.

## Patentansprüche

1. Verfahren zur drahtlosen Übertragung eines digitalen Signals, insbesondere für die mobile Kommunikation, von einem Sender mit Antenne zu einem Empfänger mit Antenne, bei dem das Signal in dem Sender (2 bis 8; 16 bis 26) moduliert wird und über einen Übertragungskanal zu dem Empfänger (11 bis 15; 29 bis 57) gelangt,
**dadurch gekennzeichnet**, dass im Sender das digitale Signal zunächst in eine Quasi-Dirac-Impulsfolge um geformt wird, wobei die Quasi-Dirac-lmpulsfolge durch einen Tiefpassfilter derart bandbegrenzt wird, dass die Quasi-Dirac-lmpulsfolge in eine Folge von Spaltimpulsen umgewandelt wird, deren Form durch die si-Funktion si(x)=^{sinx}/ₓ beschrieben wird, welche anschließend auf eine Trägerfrequenz moduliert und dann zur Expansion einem dispersiven Filter zugeführt wird, so dass ausgangsseitig eine frequenzrnodulierte Impulsfolge ausgegeben wird, wobei ein übertragender Impuls empfangsseitig derart zeitlich komprimiert wird, dass ein Impuls mit gegenüber den ausgesandten Impulsen verkürzter Dauer und erhöhter Amplitude entsteht.

2. Verfahren nach Anspruch 1, **dadurch gekennzeichnet,** daß die Winkelmodulation und das weitere Modulationsverfahren mindestens annähernd orthogonale Modulationsarten sind.

3. Verfahren nach Anspruch 1 oder 2, **dadurch gekennzeichnet,** daß die Impulse entsprechend einer vorgegebenen Filtercharakteristik gefiltert werden, wobei die senderseitige Winkelmodulation und das empfängerseitige Gruppenlaufzeitverhalten des Dispersionsfilters (13, 32, 33) derart aufeinander abgestimmt sind, daß Signalanteile der winkelmodulierten Impulse (s₆) des Ausgangssignals (s₉, g₁₄) aufgrund der frequenzabhängig unterschiedlichen Signallaufzeit des Dispersionsfilters (13, 32, 33) an dessen Ausgang im wesentlichen koinzident und infolge der Überlagerung mit gegenüber dem Eingang erhöhter Amplitude erscheinen.

4. Verfahren nach einem der vorhergehenden Ansprüche, **dadurch gekennzeichnet,** daß das Eingangssignal (g₄) eine Trägerfrequenz aufweist, die im Sender (16 bis 26) jeweils impulsweise der Winkelmodulation unterworfen wird.

5. Verfahren nach Anspruch 4, **dadurch gekennzeichnet,** daß die Modulationscharakteristik der Winkelmodulation die zeitliche Änderung des Phasenwinkels jeweils während der Dauer eines Impulses bestimmt,
daß insbesondere die Amplitude der winkelmodulierten Impulse zur Aufprägung der im Eingangssignal (s₁) enthaltenen Nachricht in Abhängigkeit vom Eingangssignal (s₁) genutzt wird,
daß das Gruppenlaufzeitverhalten des Dispersionsfilters (13) im Empfänger (11 bis 15) zur Frequenz-Zeit-Charakteristik der Sendeimpulse komplementär ist und
daß die Amplitude der von dem Dispersionsfilter (13) komprimierten Impulse zur Rückgewinnung der in dem Eingangssignal (s₁) enthaltenen Nachricht mittels eines Detektors (14, 15), insbesondere eines Amplitudendemodulators, ausgewertet wird.

6. Verfahren nach einem der vorhergehenden Ansprüche, **dadurch gekennzeichnet,** daß das weitere, die Nachricht aufprägende Modulationsverfahren insbesondere eine Pulspositionsmodulation (PPM), wahlweise auch eine Pulscodemodulation (PCM) oder eine differentielle Pulscodemodulation (DPCM) oder eine Pulsdeltamodulation (PDM) oder eine Modifikation eines oder mehrerer dieser Modulationsverfahren, ist.

7. Verfahren nach einem der Ansprüche 3 bis 6, **dadurch gekennzeichnet,** daß die im Sender winkelmodulierte Impulsfolge im Empfänger (29 bis 37) einem Dispersionsfilterpaar (32, 33) zugeführt werden, wobei die Dispersionsfilter (32, 33) des Paares unterschiedliches Gruppenlaufzeitverhalten aufweisen, das an die Modulationscharakteristik jeweils paarweise derart angepaßt ist, daß die Signalanteile der Impulse am Ausgang nur eines der Dispersionsfilter (32, 33) mit Amplitudenerhöhung erscheinen, während bei dem jeweils anderen Dispersionfilter (33, 32) eine gleichartige Amplitudenerhöhung nicht stattfindet, und daß die Amplituden am Ausgang der Dispersionsfilter (13, 32, 33) mittels eines Detektors (14, 15, 34, 35) vergleichend ausgewertet werden.

8. Verfahren nach Anspruch 7, **dadurch gekennzeichnet,** daß sich während der Pulsdauer der pulsmodulierten Signale der Winkel - die Frequenz oder die Phase - der Trägerfrequenz linear mit der Zeit von einer unteren Frequenz oder Phasenlage zu einer oberen Frequenz oder Phasenlage bzw. umgekehrt monoton ändert und daß das Dispersionsfilter im Empfänger ein komplementäres lineares oder monotones Verhalten aufweist.

9. Verfahren nach einem der vorhergehenden Ansprüche, **dadurch gekennzeichnet,** daß die Modulationscharakteristik für die einzelnen Impulse einer Folge von Impulsen unterschiedlich gewählt ist derart, daß die Unterschiede einen Teil der Nachricht ausdrücken.

10. Verfahren nach einem der vorhergehenden Ansprüche, **dadurch gekennzeichnet,**
daß zur Anpassung von Sender (2 bis 8, 16 bis 26) und Empfänger (11 bis 15, 29 bis 37) während eines Anpassungsvorgangs zum Abgleich ein vorgegebenes digitales Referenzsignal als Eingangssignal (s₁, g₄) übertragen wird,
daß während des Anpassungsvorgangs die Amplitude oder die Impulsdauer des Ausgangssignals (s₇, g₁₀, g₁₁) des empfängerseitigen Dispersionsfilters (13, 32, 33) gemessen und die senderseitig verwendete Modulationscharakteristik oder das Gruppenlaufzeitverhalten des empfängerseitigen Dispersionsfilters (13, 32, 33) verändert wird, bis die Impulsdauer einen Minimalwert bzw. die Amplitude einen Maximalwert annimmt.

11. Verfahren nach einem der Ansprüche 7 bis 10, **dadurch gekennzeichnet,**
daß der Signalfluß im Empfänger in zwei parallele Zweige mit jeweils zwei Dispersionsfiltern (39, 44, 40, 43) mit zueinander inversen Gruppenlaufzeitcharakteristiken aufgeteilt wird,
daß der Signalfluß in den beiden Zweigen jeweils während eines Impulses für einen vorgegebenen Zeitraum durchgeschaltet oder unterbrochen wird, wobei die Unterbrechung bzw. Durchschaltung synchron zum Übertragungstakt erfolgt und
daß die beiden Zweige ausgangsseitig durch einen Subtrahierer (45) zusammengeführt werden.

12. Sender-Empfänger-Anordnung mit einem Sender zur Aufnahme und Übertragung eines Eingangssignals, wobei der Sender Mittel zur Modulation des digitalen Signals aufweist,
**dadurch gekennzeichnet**, dass senderseitig Mittel vorgesehen sind, das digitale Signal zunächst in eine Quasi-Dirac-Impulsfolge umzuformen, wobei senderseitig ein Tiefpassfilter vorgesehen ist, um die Quasi-Dirac-lmpulsfolge bandzubegrenzen, und zwar derart, dass die Quasi-Dirac-lmpulsfolge in einer Folge von Spaltimpulsen umgewandelt wird, deren Form durch die si-Funktion si(x)=^{sinx}/ₓ beschrieben wird, welche mittels eines entsprechenden Modulators auf eine Trägerfrequenz moduliert und zur Expansion senderseitig einem dispersiven Filter zugeführt wird, so dass der Sender ausgangsseitig eine frequenzmodulierte Impulsfolge ausgibt und dass im Empfänger die Impulsfolge mittels eines Filters mit frequenzabhängiger differentieller Laufzeit, auch Gruppenlaufzeit genannt, derart zeitlich komprimierbar ist, dass lmpulse mitgegenüber den übertragenden frequenzmodulierten Impulsen in verkürzter Dauer und erhöhten Amplituden entstehen.

13. Anordnung nach Anspruch 12, **dadurch gekennzeichnet,**
daß der erste Modulator (16 bis 24) eine Folge winkelmodulierter Impulse erzeugt, wobei die Winkelmodulation in Abhängigkeit von dem am Steuereingang anliegenden Eingangssignal (g₄) entweder entsprechend einer vorgegebenen ersten Modulationscharakteristik oder entsprechend einer vorgegebenen zweiten Modulationscharakteristik erfolgt,
daß der Empfänger (29 bis 37) zwei parallelgeschaltete Dispersionsfilter (32, 33) aufweist, wobei das unterschiedliche Gruppenlaufzeitverhalten der beiden Dispersionsfilter (32, 33) und die erste und zweite Modulationscharakteristik derart aneinander angepaßt sind, daß am Ausgang genau eines der beiden Dispersionsfilter (32, 33) die Signalanteile der winkelmodulierten Impulsfolge zeitlich komprimiert und mit einer Amplitudenerhöhung erscheinen.

14. Anordnung nach Anspruch 12 oder 13, **dadurch gekennzeichnet,**
daß der senderseitige erste Modulator (16 bis 24) zur Erzeugung der entsprechend den beiden Modulationscharakteristiken winkelmodulierten Impulse jeweils ein Dispersionsfilter (22, 23) aufweist,
daß die in dem ersten Modulator (16 bis 24) angeordneten Dispersionsfilter (22, 23) eingangsseitig über ein steuerbares Schaltelement (21) mit einer Signalquelle (16 bis 20) verbunden sind, welche ein Hochfrequenzsignal (g₃) mit einer im wesentlichen si-förmigen Hüllkurve erzeugt,
daß das Schaltelement (21) zur Ansteuerung durch das Eingangssignal (g₄) mit dem Steuereingang des Modulators (16 bis 24) verbunden ist.

15. Anordnung nach Anspruch 12 oder 13, **dadurch gekennzeichnet,**
daß der erste Modulator (2 bis 6) winkelmodulierte Impulse erzeugt, wobei die Winkelmodulation unabhängig vom Eingangssignal (s₁) entsprechend einer vorgegebenen Modulationscharakteristik erfolgt, welche die zeitliche Änderung der Frequenz jeweils während der Dauer eines Impulses bestimmt,
daß der senderseitige zweite Modulator (4) zur Aufprägung der in dem Eingangssignal (s₁) enthaltenen Nachricht ein Amplitudenmodulator (4) ist, welcher die Amplitude der winkelmodulierten Impulse in Abhängigkeit von dem Eingangssignal (s₁) vorgibt,
daß der Empfänger (11 bis 15) zur Filterung der senderseitig entsprechend der vorgegebenen Modulationscharakteristik winkelmodulierten Impulse genau ein Dispersionsfilter (13) mit einem vorgegebenen Gruppenlaufzeitverhalten aufweist, welches derart an die senderseitig verwendete Modulationscharakteristik angepaßt ist, daß die Signalanteile jedes winkelmodulierten Impulses am Ausgang des Dispersionsfilters (13) zeitlich komprimiert und mit einer Amplitudenerhöhung erscheinen, und
daß dem Dispersionsfilter (13) zur Rückgewinnung der in dem Eingangssignal (s₁) enthaltenen Nachricht ein Detektor (14, 15) nachgeschaltet ist.

16. Anordnung nach einem der Ansprüche 12 bis 15, da**durch gekennzeichnet,** daß Sender (2 bis 8, 16 bis 26) und Empfänger (11 bis 15, 29 bis 37) zur Ermöglichung eines wechselweisen Sende- und Empfangsbetriebs jeweils korrespondierende, im wesentlichen baugleiche Baugruppen zur Modulation bzw. Demodulation aufweisen, die jeweils mindestens ein Dispersionsfilter (6, 13, 22, 23, 32, 33) enthalten.

17. Anordnung nach einem der Ansprüche 12 bis 16, **dadurch gekennzeichnet,**
daß der Empfänger (11 bis 15, 29 bis 37) ausgangsseitig ein Meßgerät aufweist zur Messung der Amplitude und/oder der Impulsdauer des Ausgangssignals (s₉, g₁₄) und
daß im Empfänger (11 bis 15, 29 bis 37) ein Stellglied vorgesehen ist zur Einstellung des Gruppenlaufzeitverhaltens des Dispersionsfilters (13, 32, 33), das, insbesondere über eine mit dem Meßgerät verbundene Steuereinheit, derart angesteuert wird, daß die Amplitude des Ausgangssignals einen Maximalwert bzw. die Impulsdauer des Ausgangssignals einen Minimalwert annimmt.

18. Anordnung nach einem der Ansprüche 12 bis 17, **dadurch gekennzeichnet,** daß der Empfänger eine Rauschunterdrückungsschaltung (38, 47) aufweist, die im wesentlichen aus zwei parallel geschalteten Zweigen besteht, die ausgangsseitig mit den Eingängen eines Subtrahierers (45, 54) verbunden sind und in denen jeweils zwei Dispersionsfilter (39, 44, 40, 43, 48, 52, 49, 53) mit zueinander inversen Gruppenlaufzeitcharakteristiken in Reihe geschaltet sind, wobei in jedem der beiden Zweige zwischen den beiden Dispersionsfiltern (39, 44, 40, 43, 48, 52, 49, 53) zur Steuerung des Signalflusses ein Steuerelement (41, 42, 50, 51) angeordnet ist, das zur Synchronisation der Signalflußsteuerung mit dem Übertragungstakt mit einer Synchronisierungsschaltung (46, 55 bis 57) verbunden ist.

19. Anordnung nach Anspruch 18, **dadurch gekennzeichnet,** daß das Steuerelement ein Multiplizierer (50, 51) ist, der eingangsseitig mit dem vorgeschalteten Dispersionsfiltern (48, 49) und zur zeitgesteuerten Unterbrechung oder Freischaltung des Signalflusses mit der Synchronisierungsschaltung (55 bis 57) verbunden ist.

## Claims

1. A process for the wireless transmission of a digital signal, in particular for mobile communication, from a transmitter having an aerial to a receiver having an aerial, in which the signal is modulated in the transmitter (2 to 8; 16 to 26) and reaches the receiver (11 to 15; 29 to 57) by way of a transmission channel, **characterised in that** the digital signal is firstly converted into a quasi Dirac pulse train in the transmitter, a low-pass filter band-limiting the quasi Dirac pulse train such that the quasi Dirac pulse train is converted into a train of split pulses, the shape of which is described by the si function si(x)=^{sinx}/ₓ, which is then modulated to a carrier frequency and then supplied to a dispersive filter for the purpose of expansion, so that a frequency-modulated pulse train is output at the output side, a transmitting pulse being time-compressed at the input side to produce a pulse which has a shorter duration and higher amplitude than the emitted pulses.

2. A process according to Claim 1, **characterised in that** the angle modulation and the further modulation process are at least approximately orthogonal modulation types.

3. A process according to Claim 1 or 2, **characterised in that** the pulses are filtered according to a predetermined filter characteristic, the angle modulation at the transmitter side and the group delay-time behaviour of the dispersion filter (13, 32, 33) at the receiver side being tuned to one another such that signal components of the angle-modulated pulses (s₆) of the output signal (s₉, g₁₄) are substantially coincident at the output side of the dispersion filter (13, 32, 33) as a result of the signal delay time thereof, which varies depending on the frequency, and appear with a higher amplitude than the input owing to the superimposition.

4. A process according to one of the preceding claims, **characterised in that** the input signal (g₄) has a carrier frequency which is subjected to the angle modulation in the transmitter (16 to 26) in each case in pulsed manner.

5. A process according to Claim 4, **characterised in that** the modulation characteristic of the angle modulation determines the time-alteration of the phase angle in each case within the duration of one pulse, in that in particular the amplitude of the angle-modulated pulses is used to impress the information contained in the input signal (s₁) in dependence on the input signal (s₁), in that the group delay-time behaviour of the dispersion filter (13) in the receiver (11 to 15) is complementary to the frequency time characteristic of the initial pulses, and in that the amplitude of the pulses compressed by the dispersion filter (13) is analysed by means of a detector (14, 15), in particular an amplitude modulator, for the purpose of retrieving the information contained in the input signal (s₁).

6. A process according to one of the preceding claims, **characterised in that** the further modulation process impressing the information is in particular a pulse position modulation (PPM), optionally also a pulse code modulation (PCM) or a differential pulse code modulation (DPCM) or a pulse delta modulation (PDM) or a modification of one or more of these modulation processes.

7. A process according to one of Claims 3 to 6, **characterised in that** the pulse trains which are anglemodulated in the transmitter are supplied to a dispersion-filter pair (32, 33) in the receiver (29 to 37), the dispersion filters (32, 33) of the pair having a differing group delay-time behaviour which is matched in each case in pairs to the modulation characteristic, in that the signal components of the pulses at the output of only one of the dispersion filters (32, 33) appear with a higher amplitude, whilst, with the in each case other dispersion filter (33, 32), there is no similar increase in amplitude, and in that the amplitudes at the output of the dispersion filters (13, 32, 33) are analysed comparatively by means of a detector (14, 15, 34, 35).

8. A process according to Claim 7, **characterised in that**, within the pulse duration of the pulse-modulated signals, the angle - the frequency or the phase - of the carrier frequency undergoes a monotonic linear change over time from a low frequency or phase position to a high frequency or phase position or vice versa, and in that the dispersion filter in the receiver has a complementary linear or monotonic behaviour.

9. A process according to one of the preceding claims, **characterised in that** the modulation characteristic for the individual pulses of a train of pulses is selected to differ such that the differences express part of the information.

10. A process according to one of the preceding claims, **characterised in that** a predetermined digital reference signal is transmitted as the input signal (s₁, g₄) for the purpose of matching the transmitter (2 to 8, 16 to 28) and the receiver (11 to 15, 29 to 37) during a matching procedure for the purpose of adjustment, in that, during the matching procedure, the amplitude or the pulse duration of the output signal (s₇, g₁₀, g₁₁) of the dispersion filter (13, 32, 33) at the receiver side is measured and the modulation characteristic used at the transmitter side or the group delay-time behaviour of the dispersion filter (13, 32, 33) at the receiver side is altered until the pulse duration assumes a minimum value or the amplitude assumes a maximum value.

11. A process according to one of Claims 7 to 10, **characterised in that** the signal flow in the receiver is divided into two parallel branches, each having two dispersion filters (39, 44, 40, 43) with mutually inverse group delay-time characteristics, in that the signal flow in the two branches is connected or interrupted in each case for a predetermined time period during one pulse, the interruption or connection taking place synchronously with the transmission clock-pulse, and in that the two branches are brought together at the output side by a subtractor (45).

12. A transmi-tter/receiver arrangement having a transmitter for receiving and transmitting an input signal, the transmitter having means for modulating the digital signal, **characterised in that** means are provided at the transmitter side which convert the digital signal firstly into a quasi Dirac pulse train, a low-pass filter being provided at the transmitter side in order to band-limit the quasi Dirac pulse train such that the quasi Dirac pulse train is converted into a train of split pulses, the shape of which is described by the si function si(x)=^{sinx}/ₓ, which is modulated to a carrier frequency by means of an appropriate modulator and supplied to a dispersive filter at the transmitter side for the purpose of expansion so that the transmitter outputs a frequency-modulated pulse train at the output side, and in that the pulse train can be time-compressed in the receiver by means of a filter having a frequency-dependent differential delay time, also called a group delay time, to produce pulses which have a shorter duration and higher amplitudes than the transmitting frequency-modulated pulses.

13. An arrangement according to Claim 12, **characterised in that** the first modulator (16 to 24) generates a train of angle-modulated pulses, the angle modulation taking place either according to a predetermined first modulation characteristic or according to a predetermined second modulation characteristic in dependence on the input signal (g₄) at the control input, in that the receiver (29, to 37) has two dispersion filters (32, 33) connected in parallel, the differing group delay-time behaviour of the two dispersion filters (32, 33) and the first and second modulation characteristic being matched to one another such that the signal components of the angle-modulated pulse train are time-compressed and appear with a higher amplitude at the output of precisely one of the two dispersion filters (32, 33).

14. An arrangement according to Claim 12 or 13, **characterised in that** the first modulator (16 to 24) at the transmitter side has in each case one dispersion filter (22, 23) for the purpose of generating the pulses which are angle-modulated according to the two modulation characteristics, in that the dispersion filters (22, 23) arranged in the first modulator (16 to 24) are connected at the input side to a signal source (16 to 20) by way of a controllable switch element (21), said signal source generating a high-frequency signal (g₃) having a substantially si-shaped envelope curve, and in that the switch-element (21) is connected to the control input of the modulator (16 to 24) for the purpose of activation by the input signal (g4).

15. An arrangement according to Claim 12 or 13, **characterised in that** the first modulator (2 to 6) generates angle-modulated pulses, the angle modulation taking place independently of the input signal (s₁) according to a predetermined modulation characteristic, which determines the time-alteration of the frequency in each case within the duration of one pulse, in that the second modulator (4) at the transmitter side is an amplitude modulator which impresses the information contained in the input signal (s₁) and predetermines the amplitude of the angle-modulated pulses in dependence on the input signal (s₁), in that, for the purpose of filtering the pulses which are angle-modulated at the transmitter side according to the predetermined modulation characteristic, the receiver (11 to 15) has precisely one dispersion filter (13) having a predetermined group delay-time behaviour which is matched to the modulation characteristic used at the transmitter side such that the signal components of each angle-modulated pulse appear time-compressed and with a higher amplitude at the output of the dispersion filter (13), and in that a detector (14, 15) is connected downstream of the dispersion filter (13) for the purpose of retrieving the information contained in the input signal (s₁).

16. An arrangement according to one of Claims 12 to 15, **characterised in that**, to enable an alternate transmitting and receiving operation, the transmitter (2 to 8, 16 to 26) and the receiver (11 to 15, 29 to 37) each have corresponding, substantially structurally identical assemblies for modulation and demodulation respectively, which each contain at least one dispersion filter (6, 13, 22, 23, 32, 33).

17. An arrangement according to one of Claims 12 to 16, **characterised in that** the receiver (11 to 15, 29 to 37) has a measuring device at the output side for the purpose of measuring the amplitude and/or the pulse duration of the output signal (s₉, g₁₄), and that en adjusting element is provided in the receiver (11 to 15, 29 to 37) for the purpose of adjusting the group delay-time behaviour of the dispersion filter (13, 32, 33) which is activated in particular by way of a control unit connected to the measuring device, such that the amplitude of the output signal assumes a maximum value and the pulse duration of the output signal assumes a minimum value.

18. An arrangement according to one of Claims 12 to 17, **characterised in that** the receiver has a noise cancellation circuit (38, 47) which comprises substantially two branches which are connected in parallel and are connected at the output side to the inputs of a subtractor (45, 54), and in which in each case two dispersion filters (39, 44, 40, 43, 48, 52, 49, 53) having mutually inverse group delay-time characteristics are connected in series, a control element (41, 42, 50, 51) being arranged in each of the two branches between the two dispersion filters (39, 44, 40, 43, 48, 52, 49, 53) for the purpose of controlling the signal flow, said control element being connected to a synchronising circuit (46, 55 to 57) for the purpose of synchronising the signal-flow control with the transmission clock-pulse.

19. An arrangement according to Claim 18, **characterised in that** the control element is a multiplier (50, 51) which is connected at the input side to the dispersion filter (48, 49) connected upstream, and to the synchronising circuit (55 to 57) for the purpose of time-controlled interruption or clearing of the signal flow.

## Revendications

1. Procédé pour la transmission sans fil d'un signal numérique, en particulier pour la communication mobile, d'un émetteur avec antenne à un récepteur avec antenne, selon lequel le signal est modulé dans l'émetteur (2 à 8 ; 16 à 26) et parvient par un canal de transmission au récepteur (11 à 25 ; 29 à 57),
**caractérisé en ce que** le signal numérique est converti tout d'abord dans l'émetteur en une quasi série d'impulsions de Dirac, la quasi série d'impulsions de Dirac étant limitée en bande par un filtre passe-bas de telle façon que la quasi série d'impulsions de Dirac soit convertie en une série d'impulsions de clivage, dont la forme est décrite par la fonction sinus cardinal si (x) = ^{sinusx}/_{X}, laquelle est modulée ensuite sur une fréquence porteuse et est amenée ensuite pour l'expansion à un filtre dispersif, de sorte qu'une série d'impulsions modulées en fréquence soit émise côté sortie, une impulsion de transmission étant comprimée côté réception de telle façon qu'une impulsion se forme avec une durée réduite et une amplitude augmentée par rapport aux impulsions émises.

2. Procédé selon la revendication 1, **caractérisé en ce que** la modulation angulaire et l'autre procédé de modulation sont des types de modulation approximativement orthogonaux.

3. Procédé selon la revendication 1 ou 2, **caractérisé en ce que** les impulsions sont filtrées en fonction d'une caractéristique de filtre prédéfinie, la modulation angulaire côté émetteur et la caractéristique de temps de propagation de groupe côté récepteur du filtre de dispersion (13, 32, 33) étant harmonisées entre elles de telle façon que des fractions de signal des impulsions (s₆) modulées en angle du signal de sortie (s₉, g₁₄) apparaissent sensiblement coïncidentes en raison du retard du signal, variable selon la fréquence, du filtre de dispersion (13, 32, 33) à sa sortie et en raison de la superposition avec.une amplitude élevée par rapport à l'entrée.

4. Procédé selon l'une quelconque des revendications précédentes, **caractérisé en ce que** le signal d'entrée (g₄) présente une fréquence porteuse, qui est soumise dans l'émetteur (16 à 26) respectivement par impulsion à la modulation angulaire.

5. Procédé selon la revendication 4, **caractérisé en ce que** la caractéristique de modulation de la modulation angulaire détermine la variation dans le temps de l'angle de phase respectivement pendant la durée d'une impulsion, et en ce qu'en particulier l'amplitude des impulsions modulées en angle est utilisée pour marquer l'information incluse dans le signal d'entrée (s₁) en fonction du signal d'entrée (s₁),
et en ce que la caractéristique de temps de propagation de groupe du filtre de dispersion (13) dans le récepteur (11 à 15) est complémentaire pour la caractéristique de fréquence - temps des impulsions d'émission et
en ce que l'amplitude des impulsions comprimées par le filtre de dispersion (13) pour la récupération de l'information contenue dans le signal d'entrée (s₁) est analysée au moyen d'un détecteur (14, 15), en particulier d'un démodulateur d'amplitude.

6. Procédé selon l'une quelconque des revendications précédentes, **caractérisé en ce que** l'autre procédé de modulation qui marque l'information, est en particulier une modulation d'impulsions en position (PPM), au choix également une modulation par impulsions codées (MIC) ou une modulation différentielle par impulsions codées (DPCM) ou une modulation delta par impulsions (MDP) ou une modification d'un ou de plusieurs de ces procédés de modulation.

7. Procédé selon l'une quelconque des revendications 3 à 6, **caractérisé en ce que** la séquence d'impulsions modulées en angle dans l'émetteur est amenée dans le récepteur 29 à 37 à une paire de filtres de dispersion (32, 33), les filtres de dispersion (32, 33) de la paire présentant une caractéristique de temps de propagation de groupe différente, qui est adaptée à la caractéristique de modulation respectivement par paire de telle façon que les fractions de signal des impulsions apparaissent à la sortie d'un seul des filtres de dispersion (32, 33) avec une augmentation d'amplitude, alors qu'il n'y a pas une augmentation d'amplitude du même type avec l'autre filtre de dispersion (33, 32), et en ce que les amplitudes à la sortie des filtres de dispersion (13, 32, 33) sont analysées de façon comparative au moyen d'un détecteur (14, 15, 34, 35).

8. Procédé selon la revendication 7, **caractérisé en ce que**, pendant la durée d'impulsion des signaux, modulés par impulsion, des angles - la fréquence ou la phase - la fréquence porteuse varie linéairement avec la durée d'une fréquence ou position de phase inférieure par rapport à une fréquence ou position de phase supérieure ou inversement de façon monotone et en ce que le filtre de dispersion dans le récepteur présente un comportement linéaire ou monotone complémentaire.

9. Procédé selon l'une quelconque des revendications précédentes, **caractérisé en ce que** la caractéristique de modulation pour les différentes impulsions d'une série d'impulsions est choisie différente de telle façon que les différences expriment une partie de l'information.

10. Procédé selon l'une quelconque des revendications précédentes, **caractérisé en ce que**,
pour l'adaptation de l'émetteur (2 à 8, 16 à 26) et du récepteur (11 à 15, 29 à 37), on transmet comme signal d'entrée (s₁, g₄) un signal de référence numérique prédéfini pendant une opération d'adaptation pour l'équilibrage,
en ce que, pendant l'opération d'adaptation, l'amplitude ou la durée d'impulsion du signal de sortie (s₇, g₁₀, g₁₁) du filtre de dispersion (13, 32, 33) côté récepteur est mesurée et la caractéristique de modulation utilisée côté émetteur ou la caractéristique de temps de propagation de groupe du filtre de dispersion (13, 32, 33) côté récepteur est modifiée jusqu'à ce que la durée d'impulsion atteigne une valeur minimale et l'amplitude une valeur maximale.

11. Procédé selon l'une quelconque des revendications 7 à 10, caractérisé
en ce que le flux de signal dans le récepteur est réparti en deux branches parallèles avec respectivement deux filtres de dispersion (39, 44, 40, 43) présentant des caractéristiques de temps de propagation de groupe qui sont inverses l'une par rapport à l'autre,
en ce que le flux de signal dans les deux branches est connecté ou interrompu respectivement pendant une impulsion pour une période prédéfinie, l'interruption ou la connexion s'effectuant de façon synchrone avec le rythme de transmission et
en ce que les deux branches sont réunies côté sortie par un soustracteur (45).

12. Dispositif émetteur - récepteur avec un émetteur pour la réception et la transmission d'un signal d'entrée, l'émetteur présentant des moyens pour la modulation du signal numérique,
**caractérisé en ce qu**'il est prévu côté émetteur des moyens pour convertir le signal numérique d'abord en une quasi série d'impulsions de Dirac, un filtre passe-bas étant prévu côté émetteur afin de limiter en bande la quasi série d'impulsions de Dirac, et ce de telle façon que la quasi série d'impulsions de Dirac est convertie en une série d'impulsions de clivage, dont la forme est décrite par la fonction de sinus cardinal si(x) = sinus^{x}/ₓ, qui est modulée au moyen d'un modulateur approprié sur une fréquence porteuse et est amenée pour l'expansion côté émetteur à un filtre dispersif, de sorte que l'émetteur émet côté sortie une série d'impulsions modulées en fréquence et que, dans le récepteur, la série d'impulsions peut être comprimée dans le temps au moyen d'un filtre avec un temps de propagation différentiel dépendant de la fréquence, appelé également temps de propagation de groupe, de telle sorte que des impulsions se forment avec des amplitudes élevées et de durée réduite par rapport aux impulsions modulées en fréquence de transmission.

13. Dispositif selon la revendication 12, **caractérisé en ce que**
le premier modulateur (16 à 24) génère une série d'impulsions modulées en angle, la modulation d'angle s'effectuant en fonction du signal d'entrée (g₄) appliqué à l'entrée du contrôle soit en fonction d'une première caractéristique de modulation prédéfinie soit en fonction d'une deuxième caractéristique de modulation prédéfinie,
en ce que le récepteur (29 à 37) présente deux filtres de dispersion (32, 33), la caractéristique différente de temps de propagation de groupe des deux filtres de dispersion (32, 33) connectés en parallèle et les première et deuxième caractéristiques de modulation étant adaptées l'une à l'autre de telle façon que, à la sortie précisément: de l'un des deux filtres de dispersion (32, 33), les fractions de signal de la série d'impulsions modulées en angle apparaissent comprimées dans le temps et avec une augmentation d'amplitude.

14. Dispositif selon la revendication 12 ou 13, caractérisé
en ce que le premier modulateur (16 à 24) côté émetteur pour la génération des impulsions modulées en angle conformément aux deux caractéristiques de modulation présente respectivement un filtre de dispersion (22, 23),
en ce que les filtres de dispersion (22, 23) disposés dans le premier modulateur (16 à 24) sont reliés côté entrée par un élément de commutation (21) contrôlable à une source de signal (16 à 20), laquelle génère un signal haute fréquence (g₃) avec une courbe enveloppante sensiblement en forme de sinus cardinal,
en ce que l'élément de commutation (21) pour l'amorçage par le signal d'entrée (g₄) est relié à l'entrée de contrôle du modulateur (16 à 24).

15. Dispositif selon la revendication 12 ou 13, caractérisé
en ce que le premier modulateur (2 à 6) génère des impulsions modulées en angle, la modulation d'angle s'effectuant indépendamment du signal d'entrée (s₁) en fonction d'une caractéristique de modulation prédéfinie, qui détermine la variation dans le temps de la fréquence respectivement pendant la durée d'une impulsion,
en ce que le deuxième modulateur (4) côté émetteur pour le marquage de l'information contenue dans le signal d'entrée (s₁) est un modulateur d'amplitude (4), qui prédéfinit l'amplitude des impulsions modulées en angle en fonction du signal d'entrée (s₁),
en ce que le récepteur (11 à 15) pour le filtrage des impulsions modulées en angle côté émetteur en fonction de la caractéristique de modulation prédéfinie présente précisément un filtre de dispersion (13) avec une caractéristique prédéfinie de temps de propagation de groupe, qui est adaptée à la caractéristique de modulation utilisée côté émetteur de telle façon que les fractions de signal de chaque impulsion modulée en angle apparaissent à la sortie du filtre de dispersion (13) comprimées dans le temps et avec une augmentation d'amplitude et
en ce qu'un détecteur (14, 15) est monté en aval du filtre de dispersion (13) pour la récupération de l'information contenue dans le signal d'entrée (s₁).

16. Dispositif selon l'une quelconque des revendications 12 à 15, **caractérisé en ce que** des émetteurs (2 à 8, 16 à 26) et des récepteurs (11 à 15, 29 à 37) présentent, pour permettre un mode d'émission et de réception alternatif, respectivement correspondants, sensiblement identiques pour la modulation et la démodulation, qui contiennent respectivement au moins un filtre de dispersion (6, 13, 22, 23, 32, 33).

17. Dispositif selon l'une quelconque des revendications 12 à 16, caractérisé
en ce que le récepteur (11 à 15, 29 à 37) présente un appareil de mesure côté sortie pour la mesure de l'amplitude et/ou de la durée d'impulsion du signal de sortie (s₉, g₁₄) et
en ce qu'il est prévu un actionneur dans le récepteur (11 à 15, 29 à 37) pour le réglage de la caractéristique de temps de propagation de groupe du filtre de dispersion (13, 32, 33) qui est commandé, en particulier par une unité de commande reliée à l'appareil de mesure, de telle sorte que l'amplitude du signal de sortie atteigne une valeur maximale et la durée d'impulsion du signal de sortie une valeur minimale.

18. Dispositif selon l'une quelconque des revendications 12 à 17, **caractérisé en ce que** le récepteur présente un circuit de suppression de bruit (38, 47), qui comprend essentiellement deux branches connectées en parallèle qui sont reliées côté sortie aux entrées d'un soustracteur (45, 54) et dans lesquelles respectivement deux filtres de dispersion (39, 44, 40, 43, 48, 52, 49, 53) sont montés en série avec des caractéristiques de temps de propagation de groupe qui sont inverses l'une par rapport à l'autre, un élément de commande (41, 42, 50, 51) étant disposé dans chacune des deux branches entre les deux filtres de dispersion (39, 44, 40, 43, 48, 52, 49, 53) pour le contrôle du flux de signal, lequel élément est relié à un circuit de synchronisation (46, 55 à 57) pour la synchronisation de la commande du flux de signal avec le rythme de transmission.

19. Dispositif selon la rovendication 18, **caractérisé en ce que** l'élément de commande est un multiplicateur (50, 51), qui est relié côté entrée au filtre de dispersion (48, 49) monté en amont et est relié au circuit de synchronisation (55 à 57) pour l'interruption contrôlée dans le temps ou la libération du flux de signal.
